# EUROPEAN PATENT SPECIFICATION

(11) **EP 4 475 636 B1**
(45) Date of publication and mention of the grant of the patent: **01.04.2026**
(21) Application number: 24704674.1
(22) Date of filing: 13.02.2024
(51) Int. Cl.: G06F 1/16, G06F 1/20, H05K 1/14, H05K 1/11, H05K 1/02, H04M 1/02, H05K 3/28

(54) **ELECTRONIC DEVICE COMPRISING DEFORMABLE PRINTED CIRCUIT BOARD**
ELEKTRONISCHE VORRICHTUNG MIT VERFORMBARER LEITERPLATTE
DISPOSITIF ÉLECTRONIQUE COMPRENANT UNE CARTE DE CIRCUIT IMPRIMÉ DÉFORMABLE

(30) Priority: 18.04.2023 KR 20230050672; 13.06.2023 KR 20230075353
(43) Date of publication of application: 11.12.2024
(73) Proprietor: Samsung Electronics Co., Ltd., Suwon-si, Gyeonggi-do 16677 (KR)
(72) Inventor: LEE, Youngsun, Suwon-si, Gyeonggi-do 16677 (KR); KIM, Byeongkeol, Suwon-si, Gyeonggi-do 16677 (KR); RA, Jaeyeon, Suwon-si, Gyeonggi-do 16677 (KR); LEE, Seungjoo, Suwon-si, Gyeonggi-do 16677 (KR)
(74) Representative: HGF
(86) International application number: PCT/KR2024/002046
(87) International publication number: WO 2024/219622

(56) References cited:
- EP-A1- 4 258 827
- WO-A1-2021/235700
- KR-A- 20160 012 589
- KR-A- 20160 013 650
- KR-A- 20180 004 972
- KR-A- 20190 137 433
- KR-A- 20220 099 353
- KR-A- 20220 143 317
- US-A1- 2015 049 275

## Description

### [Technical Field]

The present disclosure relates to an electronic device including a deformable printed circuit board.

### [Background Art]

An electronic device may comprise different housings in which electronic components may be disposed. For example, each of the housings may be movable relative to each other. In order to provide various functions to a user, it may comprise a component that connects an electronic component disposed within one housing and an electronic component disposed within another housing.

The above-described information may be provided as a related art for the purpose of helping to understand the present disclosure. No claim or determination is raised as to whether any of the above-described information can be applied as a prior art related to the present disclosure.
KR 20220099353A relates to a circuit board of a foldable electronic device.

### [Disclosure]

### [Technical Solution]

The present invention is defined by the independent claim. Further aspects of the present invention are outlined in the dependent claims. An electronic device is provided. According to an embodiment, the electronic device may comprise a first housing. According to an embodiment, the electronic device may comprise a second housing. According to an embodiment, the electronic device may comprise a hinge structure (which may also be described as a hinge, a hinge portion, or a hinge assembly) that couples (e.g. moveably couples) the first housing and the second housing. In other words, in certain embodiments, the hinge structure couples the first housing to the second housing, and permits those housings to move relative to each other. According to an embodiment, the electronic device may comprise a first printed circuit board extending from the first housing (e.g. across the hinge structure) to the second housing, and at least partially deformable by movement of the second housing relative to the first housing. According to an embodiment, the first printed circuit board may comprise a first conductive layer. According to an embodiment, the first printed circuit board may comprise a second conductive layer disposed on (or above, or over, or below) the first conductive layer. According to an embodiment, the first printed circuit board may comprise at least one conductive via extending from the first conductive layer to the second conductive layer. According to an embodiment, the first printed circuit board may comprise a heat dissipation layer interposed between the first conductive layer and the second conductive layer, and comprising an opening surrounding the at least one conductive via. According to an embodiment, the first printed circuit board may comprise a non-conductive layer (or body or member of non-conductive material) at least partially disposed within the opening such that the radiating layer and the at least one conductive via are electrically disconnected (i.e. electrically isolated or insulated from one another).

An electronic device is provided. According to an embodiment, the electronic device may comprise a first housing comprising a first surface and a second surface opposite to the first surface. According to an embodiment, the electronic device may comprise a second housing comprising a third surface and a fourth surface opposite to the third surface. According to an embodiment, the electronic device may comprise a hinge structure (or hinge, hinge portion, or hinge assembly), by moveably connecting the first housing and the second housing, capable of changing an unfolded state in which a direction in which the first surface faces is the same as a direction in which the third surface faces and a folded state in which the direction in which the first surface faces is opposite to the direction in which the third surface faces. According to an embodiment, the electronic device may comprise a first printed circuit board extending from the first housing (e.g. across the hinge structure) to the second housing, and at least partially deformable by movement of the second housing relative to the first housing. According to an embodiment, the first printed circuit board may comprise a first conductive layer. According to an embodiment, the first printed circuit board may comprise a second conductive layer disposed over (or on, or above, or below) the first conductive layer. According to an embodiment, the first printed circuit board may comprise at least one conductive via penetrating (and/or connecting) the first conductive layer and the second conductive layer. According to an embodiment, the first printed circuit board may comprise a heat dissipation layer disposed between the first conductive layer and the second conductive layer, and comprising an opening penetrated by the at least one conductive via. According to an embodiment, the first printed circuit board may comprise a non-conductive layer (or body or member of non-conductive material) at least partially disposed within the opening such that the heat dissipation layer and the at least one conductive via are electrically disconnected (i.e. electrically isolated or insulated from one another). According to an embodiment, the radiating layer may be configured to transfer at least a portion of the heat in the first housing to the second housing.

### [Description of the Drawings]

FIG. 1 is a block diagram illustrating an electronic device 101 in a network environment 100 according to various embodiments.
FIG. 2A illustrates an example of an unfolded state of an exemplary electronic device according to an embodiment.
FIG. 2B illustrates an example of a folded state of an exemplary electronic device according to an embodiment.
FIG. 2C is an exploded view of an exemplary electronic device according to an embodiment.
FIG. 3A is a top plan view of an exemplary electronic device according to an embodiment.
FIG. 3B is a cross-sectional view illustrating an example in which an exemplary electronic device according to an embodiment is cut along A-A' of FIG. 3A.
FIG. 4 is a cross-sectional view of an exemplary third printed circuit board according to an embodiment.
FIG. 5 is a partial cross-sectional view illustrating a relationship between an exemplary radiating layer and a conductive via according to an embodiment.
FIG. 6 is a partial cross-sectional view illustrating a relationship between an exemplary radiating layer and a conductive via according to an embodiment.
FIGS. 7A and 7B are drawings illustrating an example of manufacturing an exemplary third printed circuit board according to an embodiment.
FIGS. 8A to 8D are drawings illustrating an example of manufacturing an exemplary third printed circuit board according to an embodiment.
FIG. 9 is a cross-sectional view of an exemplary third printed circuit board according to an embodiment.
FIG. 10 is a cross-sectional view of an exemplary third printed circuit board according to an embodiment.
FIG. 11 is a cross-sectional view of an exemplary third printed circuit board according to an embodiment.

### [Mode for Invention]

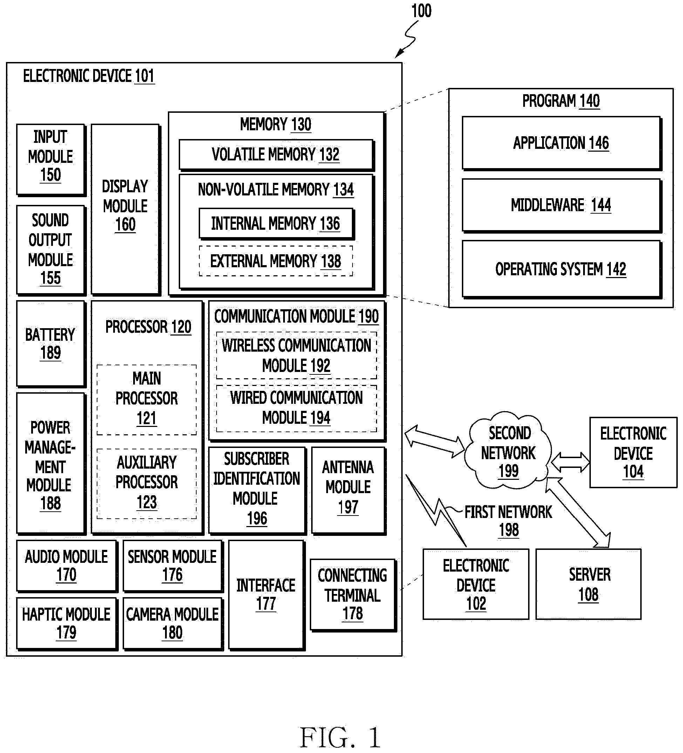

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

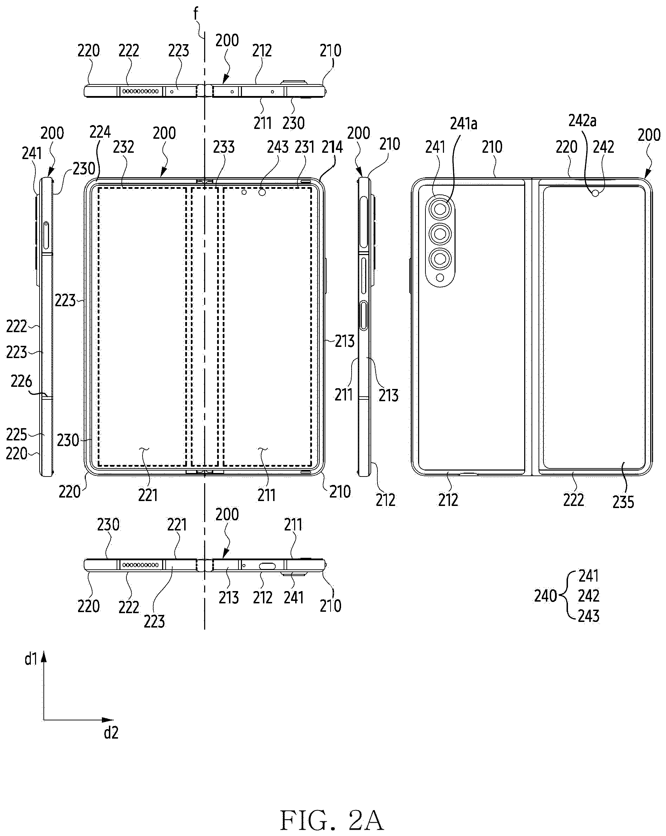

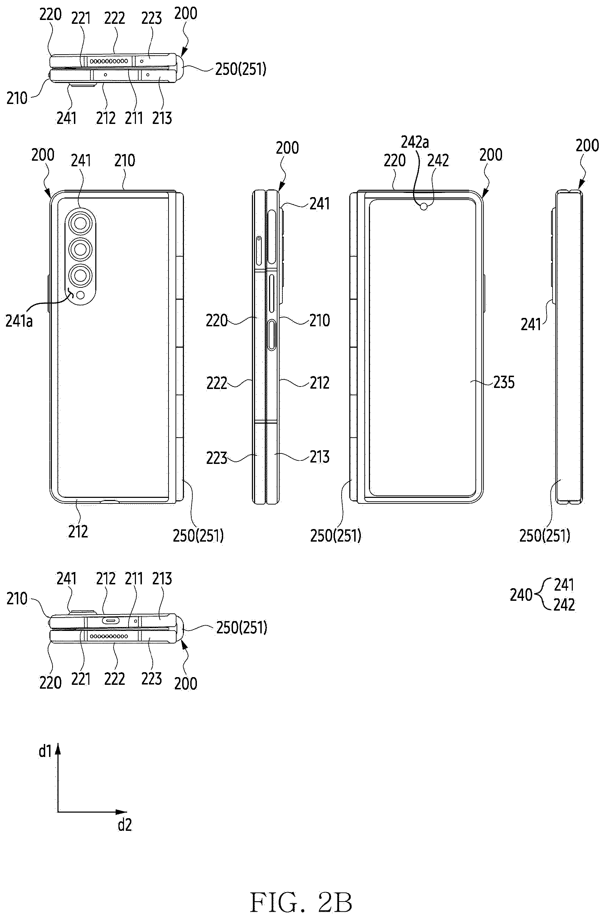

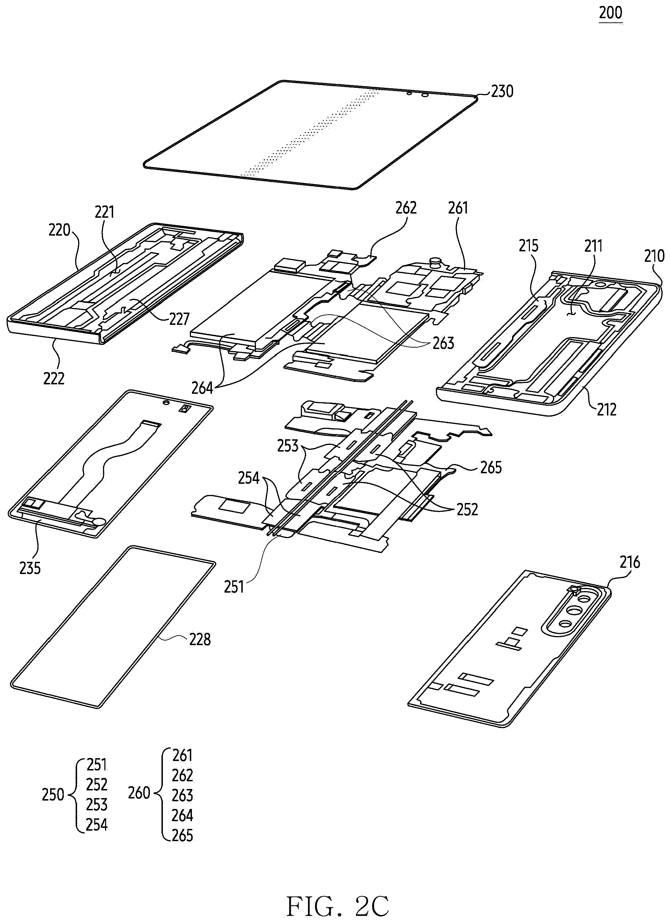

FIG. 2A illustrates an example of an unfolded state of an electronic device according to an embodiment, FIG. 2B illustrates an example of a folded state of the electronic device according to an embodiment, and FIG. 2C illustrates an exploded view of the electronic device according to an embodiment.

Referring to FIGS. 2A, 2B, and 2C, an electronic device 200 (e.g., the electronic device 101 of FIG. 1) may include a first housing 210, a second housing 220, a display 230, at least one camera 240 (e.g., the camera module 180 of FIG. 1), a hinge structure 250, and/or at least one electronic component 260.

The first housing 210 and the second housing 220 may form at least a portion of the outer surface of the electronic device 200 that may be gripped by a user. At least a portion of the outer surface of the electronic device 200 defined by the first housing 210 and the second housing 220 may be in contact with a portion of a user's body when the electronic device 200 is used by the user. According to an embodiment, the first housing 210 may include a first surface 211, a second surface 212 facing in an opposite direction to (i.e. away from) the first surface 211 and spaced apart from the first surface 211, and a first side surface 213 surrounding at least a portion of the first surface 211 and the second surface 212. The first side surface 213 may connect a periphery of the first surface 211 and a periphery of the second surface 212. The first surface 211, the second surface 212, and the first side surface 213 may define an internal space of the first housing 210. According to an embodiment, the first housing 210 may provide a space formed by the first surface 211, the second surface 212, and the first side surface 213 as a space for disposing the components of the electronic device 200.

According to an embodiment, the second housing 220 may include a third surface 221, a fourth surface 222 facing in an opposite direction to (i.e. away from) the third surface 221 and spaced apart from the third surface 221, and a second side surface 223 surrounding at least a portion of the third surface 221 and the fourth surface 222. The second side surface 223 may connect a periphery of the third surface 221 and a periphery of the fourth surface 222. The third surface 221, the fourth surface 222, and the second side surface 223 may define an internal space of the second housing 220. According to an embodiment, the second housing 220 may provide a space formed by the third surface 221, the fourth surface 222, and the second side surface 223 surrounding at least a portion of the third surface 221 and the fourth surface 222 as a space for mounting the components of the electronic device 200. According to an embodiment, the second housing 220 may be coupled to the first housing 210 so as to be rotatable (for example, about a fold or folding axis f) with respect to the first housing 210.

According to an embodiment, each of the first housing 210 and the second housing 220 may include (or comprise) a respective protection member. For example, the first housing 210 may comprise a first protection member 214, and the second housing 220 may comprise a second protection member 224. The first protection member 214 and the second protection member 224 may be disposed, respectively, on the first surface 211 and the third surface 221 along a periphery of the display 230. According to an embodiment, the first protection member 214 and the second protection member 224 may prevent inflow of foreign substance (e.g., dust or moisture) through a gap (or respective gaps) between the display 230 and the first and second housings 210 and 220. For example, the first protection member 214 may surround a periphery of a first display area 231 of the display 230, and the second protection member 224 may surround a periphery of a second display area 232 of the display 230. The first protection member 214 may be formed by being attached to the first side surface 213 of the first housing 210 or may be formed integrally with the first side surface 213. The second protection member 224 may be formed by being attached to the second side surface 223 of the second housing 220 or may be formed integrally with the second side surface 223.

According to an embodiment, the first side surface 213 and the second side surface 223 may include a conductive material (or conductive materials), a non-conductive material (or non-conductive materials), or a combination thereof. For example, the second side surface 223 may include at least one conductive member 225 (or conductive portion, region, element, or section) and at least one non-conductive member 226 (or non-conductive portion, region, element, or section). The at least one conductive member 225 may include a plurality of conductive members spaced apart from each other, respectively. The at least one non-conductive member 226 may be disposed between the plurality of conductive members. The plurality of conductive members may be disconnected from each other by the at least one non-conductive member 226 disposed between the plurality of conductive members. According to an embodiment, the plurality of conductive members and a plurality of non-conductive members may form an antenna radiator together. The electronic device 200 may be capable of communicating with an external electronic device through the antenna radiator formed by the plurality of conductive members and the plurality of non-conductive members.

The display 230 may be configured to display visual information. According to an embodiment, the display 230 may be disposed on the first surface 211 of the first housing 210 and the third surface 221 of the second housing 220 across the hinge structure 250. For example, the display 230 may include the first display area 231 disposed on the first surface 211 of the first housing, the second display area 232 disposed on the third surface 221 of the second housing, and a third display area 233 disposed between the first display area 231 and the second display area 232. The first display area 231, the second display area 232, and the third display area 233 may form a front surface of the display 230. According to an embodiment, the display 230 may further include a sub-display panel 235 disposed on the fourth surface 222 of the second housing 220. For example, the display 230 may be referred to as a flexible display. According to an embodiment, the display 230 may include a window exposed to the outside of the electronic device 200. The window may protect the surface of the display 230. The window may transmit visual information provided by the display 230 to the outside of the electronic device 200 by including a substantially transparent material. For example, the window may include, but is not limited to, glass (e.g., ultrathin glass (UTG)) and/or polymer (e.g., polyimide (PI)).

The at least one camera 240 may be configured to obtain an image based on receiving light from a subject external to the electronic device 200. According to an embodiment, the at least one camera 240 may include first cameras 241 (or a single first camera 241), a second camera 242, and a third camera 243. The first camera or cameras 241 may be disposed in the first housing 210. For example, the first camera or cameras 241 may be disposed inside the first housing 210, and at least a portion of the first camera or cameras 241 may be visible through the second surface 212 of the first housing 210. The first camera or cameras 241 may be supported by a bracket (not illustrated) in the first housing 210. The first housing 210 may include at least one opening 241a that overlaps the first camera or cameras 241 when the second surface 212 is viewed from above. The first camera or cameras 241 may obtain an image based on receiving light from the outside of the electronic device 200 through the at least one opening 241a.

According to an embodiment, the second camera 242 may be disposed in the second housing 220. For example, the second camera 242 may be disposed inside the second housing 220 and may be visible through the sub-display panel 235. The second housing 220 may include at least one opening 242a that overlaps the second camera 242 when the fourth surface 222 is viewed from above. The second camera 242 may obtain an image based on receiving light from the outside of the electronic device 200 through the at least one opening 242a.

According to an embodiment, the third camera 243 may be disposed in the first housing 210. For example, the third camera 243 may be disposed inside the first housing 210, and at least a portion of the third camera 243 may be visible through the first surface 211 of the first housing 210. For another example, the third camera 243 may be disposed inside the first housing 210, and at least a portion of the third camera 243 may be visible through the first display area 231 of the display 230. The first display area 231 of the display 230 may include at least one opening (not illustrated) that overlaps the third camera 243 when the display 230 is viewed from above. The third camera 243 may obtain an image based on receiving light from the outside of the display 230 through the at least one opening.

According to an embodiment, the second camera 242 and the third camera 243 may be disposed below the display 230 (e.g., in a direction toward the inside of the first housing 210 or the inside of the second housing 220). For example, one or both of the second camera 242 and the third camera 243 may be an under display camera (UDC). In case that the second camera 242 and the third camera 243 are under display cameras, one area of the display 230 corresponding to each location of the second camera 242 and the third camera 243 may not be an inactive area. For example, in case that the second camera 242 and the third camera 243 are under display cameras, the one area of the display 230 corresponding to each location of the second camera 242 and the third camera 243 may have a pixel density lower than a pixel density of another area of the display 230. The inactive area of the display 230 may refer to one area of the display 230 that does not include pixels or does not emit light to the outside of the electronic device 200. For another example, one or both of the second camera 242 and the third camera 243 may be punch hole cameras. In case that the second camera 242 and the third camera 243 are punch hole cameras, the one area of the display 230 corresponding to each location of the second camera 242 and the third camera 243 may be an inactive area. For example, in case that the second camera 242 and the third camera 243 are punch hole cameras, the one area of the display 230 corresponding to each location of the second camera 242 and the third camera 243 may include an opening that does not include pixels.

According to an embodiment, the hinge structure 250 (which may alternatively be described as a hinge, a hinge portion, or a hinge assembly) may couple (e.g. rotatably couple) the first housing 210 and the second housing 220. The hinge structure 250 may be disposed between the first housing 210 and the second housing 220 of the electronic device 200 so that the electronic device 200 may be bent, curved, or folded. For example, the hinge structure 250 may be disposed between a portion of the first side surface 213 and a portion of the second side surface 223 that face each other. The hinge structure 250 may be capable of changing the electronic device 200 into an unfolding state (which may alternatively be described as an unfolded state) in which directions in which the first surface 211 of the first housing 210 and the third surface 221 of the second housing 220 face are substantially the same or a folding state (which may alternatively described as a folded state) in which the first surface 211 and the third surface 221 face each other. When the electronic device 200 is in the folding (or folded) state, the first housing 210 and the second housing 220 may superimpose or overlap by facing each other. In other words, the hinge structure 250, in certain embodiments, enables the configuration of the electronic device 200 to be changed between a folded state, in which the first surface 211 and third surface 221 face each other, and an unfolded state, in which the first surface 211 and third surface 221 face in substantially the same direction.

According to an embodiment, when the electronic device 200 is in the folding (or folded) state, a direction in which the first surface 211 faces and a direction in which the third surface 221 faces may be different from each other. For example, when the electronic device 200 is in the folding state, the direction in which the first surface 211 faces and the direction in which the third surface 221 faces may be opposite to each other. For another example, when the electronic device 200 is in the folding state, the direction in which the first surface 211 faces and the direction in which the third surface 221 faces may be inclined with respect to each other. In case that the direction in which the first surface 211 faces is inclined with respect to the direction in which the third surface 221 faces, the first housing 210 may be inclined with respect to the second housing 220.

According to an embodiment, the electronic device 200 may be foldable based on a folding axis f. In other words, the electronic device 200 may be foldable and unfoldable about a folding axis f. The folding axis f may be defined by the configuration of the hinge structure 250. The folding axis f may refer to a virtual line extending through a hinge cover 251 in a direction (e.g., d1 of FIGS. 2A and 2B) substantially parallel to the longitudinal direction of the electronic device 200, but is not limited thereto. For example, the folding axis f may be a virtual line extending in a direction (e.g., d2 of FIGS. 2A and 2B) substantially perpendicular to the longitudinal direction of the electronic device 200. In case that the folding axis f extends in a direction substantially perpendicular to the longitudinal direction of the electronic device 200, the hinge structure 250 may connect the first housing 210 and the second housing 220 by extending in a direction parallel to the folding axis f. The first housing 210 and the second housing 220 may be rotatable by the hinge structure 250 extending in a direction substantially perpendicular to the longitudinal direction of the electronic device 200.

According to an embodiment, the hinge structure 250 may include the hinge cover 251, a first hinge plate 252, a second hinge plate 253, and a hinge module 254. The hinge cover 251 may surround internal components of the hinge structure 250 and form an outer surface of the hinge structure 250. According to an embodiment, when the electronic device 200 is in the folding state, at least a portion of the hinge cover 251 surrounding the hinge structure 250 may be exposed to the outside of the electronic device 200 through a space between the first housing 210 and the second housing 220. According to an embodiment, when the electronic device 200 is in the unfolding state, the hinge cover 251 may be not exposed to the outside of the electronic device 200 by being covered by the first housing 210 and the second housing 220.

According to an embodiment, the first hinge plate 252 and the second hinge plate 253 may rotatably couple the first housing 210 and the second housing 220 by coupling each of the first housing 210 and the second housing 220. For example, the first hinge plate 252 may be coupled to a first front bracket 215 of the first housing 210, and the second hinge plate 253 may be coupled to a second front bracket 227 of the second housing 220. Since the first hinge plate 252 and the second hinge plate 253 are coupled to each of the first front bracket 215 and the second front bracket 227, the first housing 210 and the second housing 220 may be rotatable according to the rotation of the first hinge plate 252 and the second hinge plate 253.

The hinge module 254 may rotate (or enable relative rotation between) the first hinge plate 252 and the second hinge plate 253. For example, the hinge module 254 may rotate the first hinge plate 252 and the second hinge plate 253 based on the folding axis f, by including gears capable of engaging with each other and rotating. According to an embodiment, the hinge module 254 may be plural. For example, a plurality of hinge modules 254 may be disposed to be spaced apart from each other at both ends of the first hinge plate 252 and the second hinge plate 253, respectively.

According to an embodiment, the first housing 210 may include the first front bracket 215 and a first rear bracket 216, and the second housing 220 may include the second front bracket 227 and a second rear bracket 228. The first front bracket 215 and the first rear bracket 216 may support components of the electronic device 200. The first front bracket 215 may define the first housing 210 by being coupled to the first rear bracket 216. The first rear bracket 216 may define a portion of the outer surface of the first housing 210. The second front bracket 227 and the second rear bracket 228 may support components of the electronic device 200. The second front bracket 227 may define the second housing 220 by being coupled to the second rear bracket 228. The second rear bracket 228 may define a portion of the outer surface of the second housing 220. For example, the display 230 may be disposed on one surface of the first front bracket 215 and one surface of the second front bracket 227. The first rear bracket 216 may be disposed on another surface of the first front bracket 215 opposite to the one surface of the first front bracket 215. The second rear bracket 228 may be disposed on another surface of the second front bracket 227 opposite to the one surface of the second front bracket 227. The sub-display panel 235 may be disposed between the second front bracket 227 and the second rear bracket 228.

According to an embodiment, a portion of the first front bracket 215 may be surrounded by the first side surface 213, and a portion of the second front bracket 227 may be surrounded by the second side surface 223. For example, the first front bracket 215 may be formed integrally with the first side surface 213, and the second front bracket 227 may be formed integrally with the second side surface 223. For another example, the first front bracket 215 may be formed separately from the first side surface 213, and the second front bracket 227 may be formed separately from the second side surface 223.

At least one electronic component 260 may implement various functions for providing to a user. According to an embodiment, the at least one electronic component 260 may include a first printed circuit board 261, a second printed circuit board 262, a flexible printed circuit board 263, a battery 264 (e.g., the battery 189 of FIG. 1), and/or an antenna 265 (e.g., the antenna module 197 of FIG. 1). The first printed circuit board 261 and the second printed circuit board 262 may form an electrical connection between components within the electronic device 200, respectively. For example, components (e.g., the processor 120 of FIG. 1) for implementing the overall function of the electronic device 200 may be disposed on the first printed circuit board 261, and electronic components for implementing some functions of the first printed circuit board 261 may be disposed on the second printed circuit board 262. For another example, components for the operation of the sub-display panel 235 disposed on the fourth surface 222 may be disposed on the second printed circuit board 262.

According to an embodiment, the first printed circuit board 261 may be disposed in the first housing 210. For example, the first printed circuit board 261 may be disposed on one surface of the first front bracket 215. According to an embodiment, the second printed circuit board 262 may be disposed in the second housing 220. For example, the second printed circuit board 262 may be spaced apart from the first printed circuit board 261 and disposed on one surface of the second front bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264 is a device for supplying power to at least one component of the electronic device 200, and may include, for example, a non-rechargeable primary battery, a rechargeable secondary battery, or a fuel cell. At least a portion of the battery 264 may be disposed on substantially the same plane as the first printed circuit board 261 or the second printed circuit board 262.

The antenna 265 may be configured to receive power or a signal from the outside of the electronic device 200. According to an embodiment, the antenna 265 may be disposed between the first rear bracket 216 and the battery 264. The antenna 265 may include, for example, a near field communication (NFC) antenna, an antenna module, and/or a magnetic secure transmission (MST) antenna. The antenna 265 may, for example, perform short-range communication with an external device or wirelessly transmit and receive power required for charging.

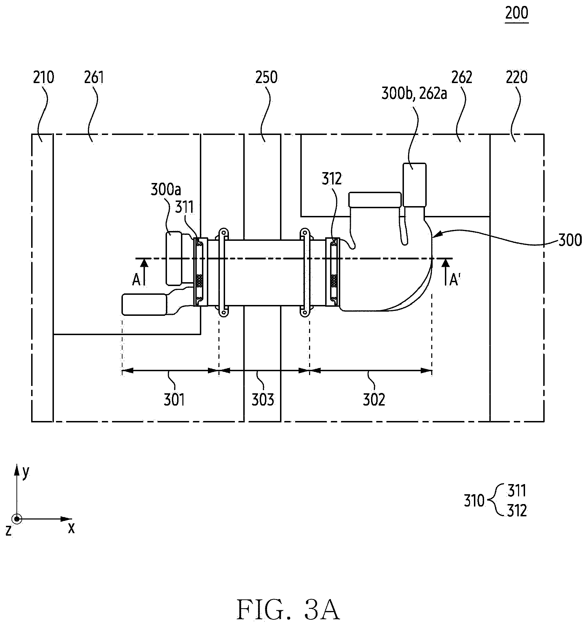

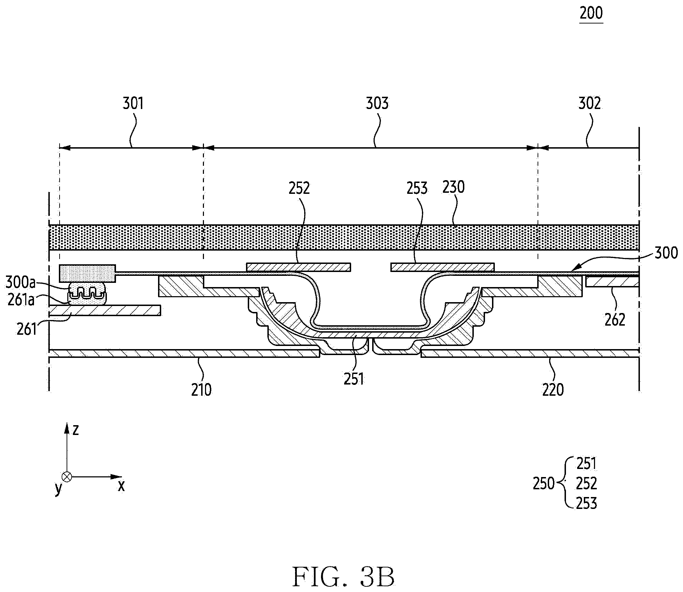

FIG. 3A is a top plan view of an exemplary electronic device according to an embodiment, and FIG. 3B is a cross-sectional view illustrating an example in which the exemplary electronic device according to an embodiment is cut along A-A' of FIG. 3A.

FIG. 3A illustrates a structure of an electronic device 200 in a state in which a first hinge plate 252 and a second hinge plate 253 of FIG. 3B are omitted.

Referring to FIGS. 3A and 3B, according to an embodiment, the electronic device 200 may include a first housing 210, a second housing 220, a display 230, a hinge structure 250, a first printed circuit board 261, a second printed circuit board 262, and/or a third printed circuit board 300.

According to an embodiment, the first housing 210 may be movable with respect to the second housing 220. The first housing 210 may be rotatable with respect to the second housing 220. The first housing 210 may support (or accommodate) a portion of a component of the electronic device 200. For example, the first housing 210 may support (or accommodate) the first printed circuit board 261. The first printed circuit board 261 may be disposed on the first housing 210.

According to an embodiment, the second housing 220 may be movable with respect to the first housing 210. The second housing 220 may be rotatable with respect to the first housing 210. The second housing 220 may support (or accommodate) another portion of the component of the electronic device 200. For example, the second housing 220 may support (or accommodate) the second printed circuit board 262.

According to an embodiment, the display 230 may be configured to provide visual information. The display 230 may be disposed on the first housing 210 and the second housing 220, across the hinge structure 250. For example, the display 230 may extend from the first housing 210 to the second housing 220, across the hinge structure 250. The display 230 may be deformable by movement of the second housing 220 with respect to the first housing 210.

According to an embodiment, the hinge structure 250 may movably couple the first housing 210 and the second housing 220. Since the first housing 210 and the second housing 220 are movable relative to each other by the hinge structure 250, a state of the electronic device 200 may be changed. The state of the electronic device 200 may include a folding (or folded) state and an unfolded state. In the folding state of the electronic device 200, at least a portion of the display 230 may be bent. Within the folding state of the electronic device 200, an area of the display 230 that is visible from the outside of the electronic device 200 may be a first area. The size of the first area may have a minimum value among the sizes of the area of the display 230 that are visible from the outside of the electronic device 200. Within the unfolding state of the electronic device 200, the display 230 may have a substantially planar shape on the first housing 210, the hinge structure 250, and the second housing 220. Within the unfolding state of the electronic device 200, the area of the display 230 that is visible from the outside of the electronic device 200 may be a second area. The size of the second area may be a maximum value among sizes of the area of the display 230 that are visible from the outside of the electronic device 200. Thus, the second area may be larger than the first area.

According to an embodiment, the hinge structure 250 may include a hinge cover 251, the first hinge plate 252, and the second hinge plate 253. The hinge cover 251 may cover (or surround) the first hinge plate 252 and the second hinge plate 253. The hinge cover 251 may define an outer surface of the hinge structure 250. For example, the hinge cover 251 may be exposed to the outside of the first housing 210 and the second housing 220 within the folding state of the electronic device 200. For example, the hinge cover 251 may be covered by the first housing 210 and the second housing 220 within the unfolding state of the electronic device 200. The first hinge plate 252 and the second hinge plate 253 may be configured to change the shape of the display 230 by moving. The first hinge plate 252 and the second hinge plate 253 may be movable with respect to each other. A direction of movement of the first hinge plate 252 may substantially correspond to a direction of movement of the first housing 210. A direction of movement of the second hinge plate 253 may substantially correspond to a direction of movement of the second housing 220. For example, the first hinge plate 252 may rotate along a first rotational direction relative to the second hinge plate 253 while the first housing 210 rotates along the first rotational direction relative to the second housing 220. For example, the second hinge plate 253 may rotate along a second rotational direction relative to the first hinge plate 252 while the second housing 220 rotates along the second rotational direction relative to the first housing 210.

According to an embodiment, the first printed circuit board 261 may be disposed on the first housing 210. For example, the first printed circuit board 261 may be accommodated in the first housing 210. The first printed circuit board 261 may support various electronic components for operation of the electronic device 200. For example, a processor (e.g., the processor 120 of FIG. 1) may be disposed on the first printed circuit board 261. In case that the processor 120 is disposed on the first printed circuit board 261, the first printed circuit board 261 may be referred to as a main printed circuit board.

According to an embodiment, the second printed circuit board 262 may be disposed on the second housing 220. For example, the second printed circuit board 262 may be accommodated in the second housing 220. The second printed circuit board 262 may support various electronic components for the operation of the electronic device 200. According to an embodiment, the second printed circuit board 262 may be spaced apart (or separated) from the first printed circuit board 261. In case that the processor 120 is disposed on the first printed circuit board 261, in order for various functions of the electronic device 200 to be implemented, an electrical connection between the first printed circuit board 261 and the second printed circuit board 262 may be required.

According to an embodiment, the third printed circuit board 300 may connect the first printed circuit board 261 and the second printed circuit board 262. The third printed circuit board 300 may electrically connect the first printed circuit board 261 and the second printed circuit board 262. For example, the third printed circuit board 300 may include conductive layers for transmission of a signal between the first printed circuit board 261 and the second printed circuit board 262. For example, the third printed circuit board 300 may include a ground layer. For example, the third printed circuit board 300 may include a first connector 300a connected (or coupled) to another connector 261a disposed on the first printed circuit board 261. Since the first connector 300a and the another connector 261a are coupled (or connected), the third printed circuit board 300 and the first printed circuit board 261 may be electrically connected. For example, the first connector 300a may be disposed on the third printed circuit board 300 through solder (not illustrated), but is not limited thereto. For example, the third printed circuit board 300 may include a second connector 300b connected (or coupled) to another connector 262a disposed on the second printed circuit board 262. Since the second connector 300b and the another connector 262a are coupled (or connected), the third printed circuit board 300 and the second printed circuit board 262 may be electrically connected. For example, the second connector 300b may be disposed on the third printed circuit board 300 through solder (not illustrated), but is not limited thereto.

According to an embodiment, the third printed circuit board 300 may extend from the first housing 210 to the second housing 220, for example across (or over, or above, or under) the hinge structure 250 to the second housing 220. For example, the third printed circuit board 300 may extend from the first printed circuit board 261 across the hinge structure 250 to the second printed circuit board 262. For example, one end of the third printed circuit board 300 may be disposed on the first printed circuit board 261, and another end of the third printed circuit board 300 may be disposed on the second printed circuit board 262. The another end of the third printed circuit board 300 may be opposite to the one end of the third printed circuit board 300.

According to an embodiment, at least a portion of the third printed circuit board 300 may be deformable by movement of the second housing 220 relative to the first housing 210. For example, the at least a portion of the third printed circuit board 300 may have flexibility. Since the at least a portion of the third printed circuit board 300 has flexibility, damage to the third printed circuit board 300 due to the movement of the second housing 220 relative to the first housing 210 may be reduced. For example, the third printed circuit board 300 may include a first area or portion 301 (which may be described as a first support area 301), a second area or portion 302 (which may be described as a second support area 302), and/or a third area or portion 303 (which may be described as a flexible area 303). The first support area 301 may be disposed on (or over, or in) the first housing 210. At least a portion of the first support area 301 may be disposed on (or over, or above) the first printed circuit board 261. The at least a portion of the first support area 301 may support the connector 300a. The at least a portion of the first support area 301 may have relatively rigidity compared to the flexible area 303. For example, the thickness of the at least a portion of the first support area 301 may be thicker than the thickness of the flexible area 303. The second support area 302 may be disposed on (or over, or in) the second housing 220. At least a portion of the second support area 302 may be disposed on (or over, or above) the second printed circuit board 262. The at least a portion of the second support area 302 may support the connector 300b. The at least a portion of the second support area 302 may have relatively rigidity compared to the flexible area 303. For example, the thickness of the at least a portion of the second support area 302 may be thicker than the thickness of the flexible area 303. The flexible area 303 may be deformable by having flexibility compared to the at least a portion of the first support area 301 and the at least a portion of the second support area 302. The flexible area 303 may be deformable by movement of the second housing 220 with respect to the first housing 210. The flexible area 303 may connect the first support area 301 and the second support area 302. The flexible area 303 may be disposed between the first support area 301 and the second support area 302. The flexible area 303 may extend from the first support area 301 to the second support area 302. At least a portion of the flexible area 303 may be disposed (or accommodated) within (or inside) the hinge structure 250. The at least a portion of the flexible area 303 may be bent within the unfolding state of the electronic device 200. In other words, at least a portion of the flexible area 303 may be in a first bent or curved state when the electronic device 200 is in the unfolded state. The at least a portion of the flexible area 303 may be bent within the folding state of the electronic device 200. In other words, at least a portion of the flexible area may be in a second bent or curved state when the electronic device is in the folded state. The first bent state may be different from the second bent state. Since the third printed circuit board 300 includes the at least a portion of the first support area 301 and the at least a portion of the second support area 302 having relative rigidity and the flexible area 303 having relative flexibility, it may be referred to as a rigid flexible printed circuit board (RFPCB).

According to an embodiment, the third printed circuit board 300 may include at least one conductive via 310. The term "conductive via" may refer to a hole (e.g. a drilled hole) that is plated, coated, or at least partly filled with a conductive material to create an electrical connection between two or more layers of a printed circuit board. The at least one conductive via 310 may electrically connect conductive layers by penetrating the conductive layers within the third printed circuit board 300. For example, the at least one conductive via 310 may be referred to as a via hole. The at least one conductive via 310 may include one or more first conductive vias 311 and one or more second conductive vias 312. The one or more first conductive vias 311 may be disposed on (or in) the first support area 301. The one or more first conductive vias 311 may be disposed outside the flexible area 303. The one or more first conductive vias 311 may be spaced apart from the flexible area 303. The one or more first conductive vias 311 may include a plurality of conductive vias spaced apart from each other. The one or more second conductive vias 312 may be disposed on (or in) the second support area 302. The one or more second conductive vias 312 may be disposed outside the flexible area 303. The one or more second conductive vias 312 may be spaced apart from the flexible area 303. The one or more second conductive vias 312 may include the plurality of conductive vias spaced apart from each other.

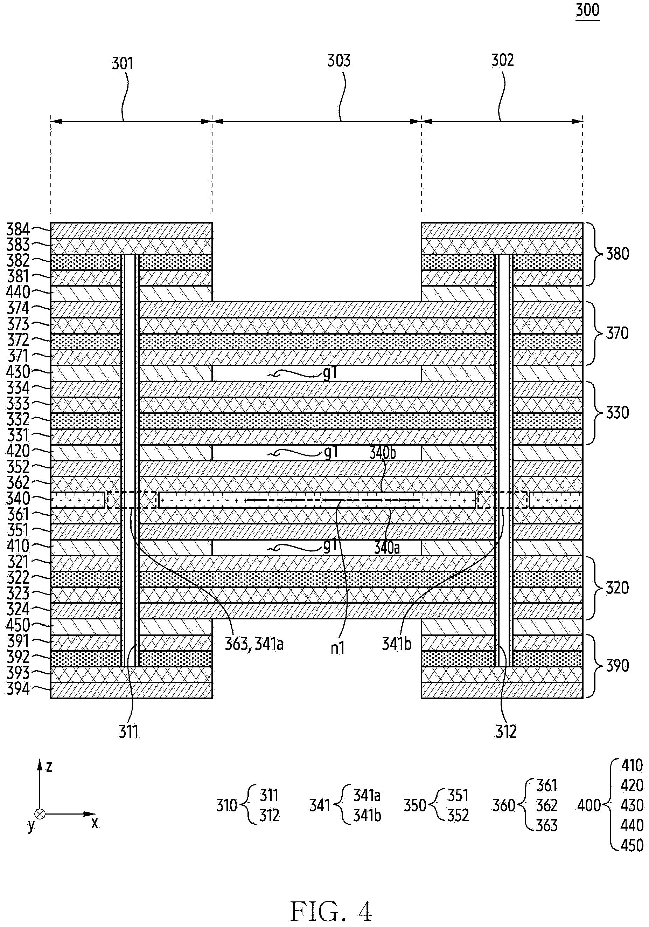

For example, heat may be generated from each of the first printed circuit board 261 and the second printed circuit board 262, since the electronic components disposed on each of the first printed circuit board 261 and the second printed circuit board 262 operate. For example, in case that heat generated from the first printed circuit board 261 is concentrated in the first housing 210, the function of the electronic components disposed on the first printed circuit board 261 may be deteriorated (or, in other words, be adversely affected) due to the heat and/or the associated temperature. A structure for transferring at least a portion of the heat in the first housing 210 to the second housing 220 may be required to reduce the concentration of the heat in the first housing 210 (and, for example, to reduce the temperature of at least one electronic component in the first housing 210). In case that a separate member for transferring the at least a portion of the heat in the first housing 210 to the second housing 220 is added, the possibility of the separate member being damaged may increase since the movement of the second housing 220 relative to the first housing 210 is repeated. In other words, repeated changes of configuration of the electronic device 200 between its folded and unfolded states could damage the separate member. In case that the member for transferring the at least a portion of the heat in the first housing 210 to the second housing 220 is added, the size of space for disposing other components in the first housing 210 and the second housing 220 may be reduced. A structure for securing space in the first housing 210 and the second housing 220 while transferring the at least a portion of the heat in the first housing 210 to the second housing 220 may be described with reference to FIG. 4.

FIG. 4 is a cross-sectional view of an exemplary third printed circuit board according to an embodiment.

Referring to FIG. 4, a third printed circuit board 300 according to an embodiment may include a first layer 320, a second layer 330, a radiating layer 340, at least one protection layer 350, a non-conductive layer 360, a third layer 370, a fourth layer 380, a fifth layer 390, and/or at least one attachment layer 400.

According to an embodiment, the first layer 320 may be disposed (or extended) within a first support area 301, a second support area 302, and a flexible area 303. In other words, the first layer 320 may comprise respective portions in each of the areas 301, 302, and 303. The first layer 320 may include a first base layer 321, a first conductive layer 322, a first adhesive layer 323, and/or a first cover layer 324. The first base layer 321 may support the first conductive layer 322. The first base layer 321 may be disposed under the radiating layer 340. For example, the first base layer 321 may be spaced apart from the radiating layer 340 along a third direction (e.g., a -z direction). For example, the first base layer 321 may include polyimide (PI), but is not limited thereto. For example, the thickness of the first base layer 321 may be approximately 12 µm, but is not limited thereto. The first conductive layer 322 may include (or provide) a conductive pattern for transmission of a signal between a printed circuit board (e.g., the first printed circuit board 261 of FIGS. 3A and 3B) and a printed circuit board (e.g., the second printed circuit board 262 of FIGS. 3A and 3B). The first conductive layer 322 may be disposed on the first base layer 321. The first conductive layer 322 may be in contact with the first base layer 321. The first conductive layer 322 may be disposed under the first base layer 321. For example, the first conductive layer 322 may be in contact with a surface of the first base layer 321 facing the third direction (e.g., the -z direction). For example, the first conductive layer 322 may include a conductive material (e.g., copper), but is not limited thereto. For example, the thickness of the first conductive layer 322 may be approximately 18 µm, but is not limited thereto. The first adhesive layer 323 may attach the first cover layer 324 on the first conductive layer 322. The first adhesive layer 323 may be disposed on the first conductive layer 322. The first adhesive layer 323 may be disposed (or interposed) between the first conductive layer 322 and the first cover layer 324. For example, the thickness of the first adhesive layer 323 may be approximately 15 µm, but is not limited thereto. The first cover layer 324 may protect the layers 321, 322, and 323 within the first layer 320. The first cover layer 324 may be disposed on the first adhesive layer 323. The first cover layer 324 may be disposed under the first adhesive layer 323. For example, the first cover layer 324 may be in contact with one surface of the first adhesive layer 323 facing the third direction (e.g., the -z direction). For example, the first cover layer 324 may include polyimide (PI), but is not limited thereto. For example, the thickness of the first cover layer 324 may be approximately 7.5 µm, but is not limited thereto.

According to an embodiment, the second layer 330 may be disposed (or extended) within the first support area 301, the second support area 302, and the flexible area 303. In other words, the second layer 330 may comprise respective portions in each of the areas 301, 302, and 303. The second layer 330 may include a second base layer 331, a second conductive layer 332, a second adhesive layer 333, and/or a second cover layer 334. The second base layer 331 may support the second conductive layer 332. The second base layer 331 may be disposed above the radiating layer 340. For example, the second base layer 331 may be spaced apart from the radiating layer 340 along a fourth direction (e.g., a +z direction). For example, the second base layer 331 may include polyimide (PI), but is not limited thereto. For example, the thickness of the second base layer 331 may be approximately 12 µm, but is not limited thereto. The second conductive layer 332 may include (or provide) a conductive pattern for transmission of a signal between the first printed circuit board 261 and the second printed circuit board 262. The second conductive layer 332 may be disposed on the second base layer 331. The second conductive layer 332 may be in contact with the second base layer 331. The second conductive layer 332 may be disposed above the second base layer 331. For example, the second conductive layer 332 may be in contact with a surface of the second base layer 331 facing the fourth direction (e.g., the +z direction) opposite to the third direction (e.g., the -z direction). For example, the second conductive layer 332 may include a conductive material (e.g., copper), but is not limited thereto. For example, the thickness of the second conductive layer 332 may be approximately 18 µm, but is not limited thereto. The second adhesive layer 333 may attach the second cover layer 334 on the second conductive layer 332. The second adhesive layer 333 may be disposed (or interposed) between the second conductive layer 332 and the second cover layer 334. For example, the thickness of the second adhesive layer 333 may be approximately 15 µm, but is not limited thereto. The second cover layer 334 may protect the layers 331, 332, and 333 within the second layer 330. The second cover layer 334 may be disposed on the second adhesive layer 333. The second cover layer 334 may be disposed above the second adhesive layer 333. For example, the second cover layer 334 may be in contact with one surface of the second adhesive layer 333 facing the fourth direction (e.g., the +z direction). For example, the second cover layer 334 may include polyimide (PI), but is not limited thereto. For example, the thickness of the second cover layer 334 may be approximately 7.5 µm, but is not limited thereto.

According to an embodiment, at least one conductive via 310 may electrically connect the first conductive layer 322 and the second conductive layer 332. The at least one conductive via 310 may penetrate the first conductive layer 322 and the second conductive layer 332. For example, the at least one conductive via 310 may penetrate the first layer 320 and the second layer 330.

According to an embodiment, the radiating layer 340 may be disposed within the first support area 301, the second support area 302, and the flexible area 303. In other words, the radiating layer 340 may comprise respective portions in each of the areas 301, 302, and 303. The radiating layer 340 may provide a path for heat transfer between the first printed circuit board 261 and the second printed circuit board 262. For example, the radiating layer 340 may include a conductive material (e.g., graphite), but is not limited thereto. Since the radiating layer 340 is disposed within the first support area 301 corresponding to the first housing (e.g., the first housing 210 of FIGS. 3A and 3B), the second support area 302 corresponding the second housing (e.g., the second housing 220 of FIGS. 3A and 3B), and the flexible area 303 between the first support area 301 and the second support area 302, heat exchange between the first housing 210 and the second housing 220 may be increased. According to an embodiment, the radiating layer 340 may be disposed (or interposed) between the first layer 320 and the second layer 330. For example, the radiating layer 340 may be interposed between the first conductive layer 322 and the second conductive layer 332. For example, the thickness of the radiating layer 340 may be approximately 40 µm, but is not limited thereto.

According to an embodiment, the radiating layer 340 may include at least one opening 341. The at least one opening 341 may be penetrated by the at least one conductive via 310. The at least one opening 341 may accommodate the at least one conductive via 310. The at least one opening 341 may cover (or surround) the at least one conductive via 310. The at least one opening 341 may provide a space for separating the radiating layer 340 from the at least one conductive via 310 so that the radiating layer 340 and the conductive via 310 are electrically disconnected. For example, the width of the opening 341 may be greater than the width of the at least one conductive via 310. The width of one component may refer to the length based on a direction from the first support area 301 to the second support area 302 (e.g., a +x direction). Thus, the opening 341 may be arranged such that the conductive via 310 passes through the opening 341 (and hence through the radiating layer 340) without making electrical contact to the radiating layer 340. The opening 341 may also be described as a window in (or through) the radiating layer 340, through which the conductive via 310 passes, from one side of the radiating layer 340 (e.g. above) to the other side of the radiating layer 340 (e.g. below). The window is sized sufficiently larger than the via's cross section, so that the via does not electrically contact or connect to the radiating layer 340 it passes through.

According to an embodiment, the at least one opening 341 may include a first opening 341a and a second opening 341b. The first opening 341a may be disposed within the first support area 301. The first opening 341a may cover (or surround) one or more first conductive vias 311. The second opening 341b may be disposed within the second support area 302. The second opening 341b may cover (or surround) one or more second conductive vias 312. The radiating layer 340 may be electrically disconnected from the at least one conductive via 310 by including the at least one opening 341. For example, since an object with high thermal conductivity has electrical conductivity, the radiating layer 340 with high thermal conductivity for heat exchange between the first housing 210 and the second housing 220 may have electrical conductivity. In case that the radiating layer 340 with electrical conductivity and the at least one conductive via 310 come into contact, a short circuit within the third printed circuit board 300 may occur. Since the radiating layer 340 and the at least one conductive via 310 are spaced apart from each other, the third printed circuit board 300 according to an embodiment may provide a structure that may inhibit the short circuit within the third printed circuit board 300 while increasing heat exchange in the first housing 210 and the second housing 220.

According to an embodiment, the at least one protection layer 350 may protect the radiating layer 340. The at least one protection layer 350 may be disposed along the radiating layer 340. The at least one protection layer 350 may be disposed (or extended) within the first support area 301, the second support area 302, and the flexible area 303. In other words, the at least one protection layer 350 may comprise respective portions in each of the areas 301, 302, and 303. For example, the at least one protection layer 350 may include a first protection layer 351 and a second protection layer 352. The first protection layer 351 may be interposed between the first layer 320 and the radiating layer 340. The first protection layer 351 may be disposed under the radiating layer 340. The first protection layer 351 may be disposed on one surface 340a of the radiating layer 340 facing the third direction (e.g., the -z direction). For example, the first protection layer 351 may be spaced apart from the one surface 340a of the radiating layer 340 along the third direction (e.g., the -z direction). For example, the thickness of the first protection layer 351 may be approximately 12.5 µm, but is not limited thereto. The second protection layer 352 may be interposed between the second layer 320 and the radiating layer 340. The second protection layer 352 may be disposed above the radiating layer 340. The second protection layer 352 may be disposed on another surface 340b of the radiating layer 340 facing the fourth direction (e.g., +z direction). The another surface 340b of the radiating layer 340 may be opposite to the one surface 340a of the radiating layer 340. For example, the second protection layer 352 may be spaced apart from the another surface 340b of the radiating layer 340 along the fourth direction (e.g., the +z direction). For example, the thickness of the second protection layer 352 may be approximately 12.5 µm, but is not limited thereto. According to an embodiment, the at least one protection layer 350 may include a heat-resistant material (e.g., polyimide (PI), polyethylene terephthalate (PET), and polyethylene naphthalate (PEN)). Since the at least one protection layer 350 has heat resistance, damage to the third printed circuit board 300 due to heat generated in a process of manufacturing the third printed circuit board 300 or heat generated in a process of manufacturing the electronic device 200 may be reduced. For example, the at least one protection layer 350 may have durability against heat transferred from solder that connects a connector (e.g., the connectors 300a and 300b of FIGS. 3A and 3B) on the third printed circuit board 300. For example, the at least one protection layer 350 may have durability against heat generated in a reflow process for disposing an electronic component within the electronic device 200.

According to an embodiment, the non-conductive layer 360 may be disposed along the radiating layer 340. The non-conductive layer 360 may cover (or surround) the radiating layer 340. The non-conductive layer 360 may be disposed (or extended) within the first support area 301, the second support area 302, and the flexible area 303. In other words, the non-conductive layer 360 may comprise respective portions in each of the areas 301, 302, and 303. The non-conductive layer 360 may electrically disconnect the radiating layer 340 and at least one conductive via 310. The non-conductive layer 360 may space the radiating layer 340 and the at least one conductive via 310 apart. For example, at least a portion of the non-conductive layer 360 may be interposed between the radiating layer 340 and the at least one conductive via 310. For example, the at least a portion of the non-conductive layer 360 may be disposed within the at least one opening 341. For example, the at least a portion of the non-conductive layer 360 may fill the at least one opening 341. The non-conductive layer 360 may include a non-conductive material. Since the non-conductive layer 360 including a non-conductive material fills the at least one opening 341, the at least one conductive via 310 and the radiating layer 340 may be electrically disconnected. According to an embodiment, the non-conductive layer 360 may include an adhesive material. For example, the non-conductive layer 360 may attach the first protection layer 351 to the radiating layer 340. For example, the non-conductive layer 360 may attach the second protection layer 352 to the radiating layer 340. Thus, it will be appreciated that, in certain embodiments, the non-conductive material of the non-conductive layer 360 at least partially fills the space (or volume) inside the opening 341 (or window) in the radiating layer 340, between the side or sides of the opening 341 (or window) and the via that passes through the opening 341 (or window), thereby ensuring that the via is kept electrically insulated from the radiating layer 340, even while the electrical device 200 is transitioned between its folded and unfolded states (which generally causes flexing of the flexible portion 303 of the third circuit board).

According to an embodiment, the non-conductive layer 360 may include a first area 361, a second area 362, and a third area 363. The first area 361 may be disposed along the one surface 340a of the radiating layer 340 facing the first conductive layer 322. The first area 361 may be disposed on the one surface 340a of the radiating layer 340. The first area 361 may be in contact with the one surface 340a of the radiating layer 340. For example, the thickness of the first area 361 may be approximately 10 µm, but is not limited thereto. The second area 362 may be disposed along the another surface 340b of the radiating layer 340 facing the second conductive layer 332. The second area 362 may be disposed on the another surface 340b of the radiating layer 340. The second area 362 may be in contact with the another surface 340b of the radiating layer 340. The second area 362 may be spaced apart from the first area 361. For example, the thickness of the second area 362 may be approximately 10 µm, but is not limited thereto. For example, the at least one opening 341 may be disposed between the first area 361 and the second area 362. The third area 363 may connect the first area 361 and the second area 362. The third area 363 may be disposed within the at least one opening 341. The third area 363 may fill the at least one opening 341. The third area 363 may cover (or surround) the at least one conductive via 310 within the at least one opening 341.

According to an embodiment, the radiating layer 340 may be interposed between layers of the third printed circuit board 300. For example, the radiating layer 340 may be interposed between the first layer 320 and the second layer 330. One area of the third printed circuit board 300 located between the first layer 320 and the second layer 330 may have a symmetrical shape with respect to the radiating layer 340. The thickness of the one area of the third printed circuit board 300 located between the first layer 320 and the second layer 330 may be symmetrical with respect to the radiating layer 340. For example, the sum of the thickness of the first area 361 disposed under the radiating layer 340 and the thickness of the first protection layer 351 may be substantially the same as the sum of the thickness of the second area 362 disposed above the radiating layer 340 and the thickness of the second protection layer 352. For example, the thickness of the first area 361 may be substantially the same as the thickness of the second area 362. For example, the thickness of the first protection layer 351 may be substantially the same as the thickness of the second protection layer 352. For example, the radiating layer 340 may be located close to a neutral plane n1 of the third printed circuit board 300. The neutral plane n1 may indicate a boundary between an area where compressive stress is generated and an area where tensile stress is generated when at least a portion of the third printed circuit board 300 is deformed. As a distance from the neutral plane n1 increases, an influence caused by stress generated when the at least a portion of the third printed circuit board 300 is deformed may increase. In other words, as the neutral plane n1 approaches, the influence caused by the stress generated when the at least a portion of the third printed circuit board 300 is deformed may be reduced. In case that the radiating layer 340 is formed of a material (e.g., graphite) that has relatively rigidity, the radiating layer 340 may be relatively vulnerable to damage. Since the radiating layer 340 is located close to the neutral plane n1, the third printed circuit board 300 according to an embodiment may provide a structure that may reduce damage caused by stress due to deformation of the third printed circuit board 300.

According to an embodiment, the third layer 370 may be disposed (or extended) within the first support area 301, the second support area 302, and the flexible area 303. The third layer 370 may include a third base layer 371, a third conductive layer 372, a third adhesive layer 373, and/or a third cover layer 374. The third base layer 371 may be disposed above the second layer 330. For example, the third base layer 371 may be spaced apart from the second layer 330 along the fourth direction (e.g., the +z direction). The third base layer 371 may include polyimide (PI), but is not limited thereto. The thickness of the third base layer 371 may be approximately 12 µm, but is not limited thereto. The third conductive layer 372 may include (or provide) a conductive pattern for transmission of a signal between the first printed circuit board 261 and the second printed circuit board 262. The third conductive layer 372 may be disposed on the third base layer 371. The third conductive layer 372 may be in contact with the third base layer 371. The third conductive layer 372 may be disposed above the third base layer 371. For example, the third conductive layer 372 may be in contact with a surface of the third base layer 371 facing the fourth direction (e.g., the +z direction). For example, the third conductive layer 372 may include a conductive material (e.g., copper), but is not limited thereto. For example, the thickness of the third conductive layer 372 may be approximately 12 µm, but is not limited thereto. The third adhesive layer 373 may attach the third cover layer 374 on the third conductive layer 372. The third adhesive layer 373 may be disposed (or interposed) between the third conductive layer 372 and the third cover layer 374. For example, the thickness of the third adhesive layer 373 may be approximately 15 µm, but is not limited thereto. The third cover layer 374 may protect the layers 371, 372, and 373 within the third layer 370. The third cover layer 374 may be disposed on the third adhesive layer 373. The third cover layer 374 may be disposed above the third adhesive layer 373. For example, the third cover layer 374 may be in contact with one surface of the third adhesive layer 373 facing the fourth direction (e.g., the +z direction). For example, the third cover layer 374 may include polyimide (PI), but is not limited thereto. For example, the thickness of the third cover layer 374 may be approximately 12.5 µm, but is not limited thereto.

According to an embodiment, the at least one conductive via 310 may penetrate the third layer 370. The at least one conductive via 310 may penetrate the third conductive layer 372. The at least one conductive via 310 may electrically connect the first conductive layer 322, the second conductive layer 332, and the third conductive layer 372 by penetrating the first layer 320, the second layer 330, and the third layer 370.

According to an embodiment, the fourth layer 380 may be disposed (or extended) within the first support area 301 and the second support area 302. The fourth layer 380 may be disposed outside the flexible area 303. The fourth layer 380 may be spaced apart from the flexible area 303. For example, a portion of the fourth layer 380 may be disposed within the first support area 301. Another portion of the fourth layer 380 may be spaced apart (or disconnected) from the portion of the fourth layer 380 and disposed within the second support area 302. The fourth layer 380 may include a fourth base layer 381, a fourth conductive layer 382, a fourth adhesive layer 383, and/or a fourth cover layer 384. The fourth base layer 381 may be disposed above the third layer 370. For example, the fourth base layer 381 may be spaced apart from the third layer 370 along the fourth direction (e.g., the +z direction). The fourth base layer 381 may include polyimide (PI), but is not limited thereto. The thickness of the fourth base layer 381 may be approximately 12 µm, but is not limited thereto. The fourth conductive layer 382 may include (or provide) a conductive pattern for transmission of a signal between the first printed circuit board 261 and the second printed circuit board 262. The fourth conductive layer 382 may be disposed on the fourth base layer 381. The fourth conductive layer 382 may be in contact with the fourth base layer 381. The fourth conductive layer 382 may be disposed above the fourth base layer 381. For example, the fourth conductive layer 382 may be in contact with a surface of the fourth base layer 381 facing the fourth direction (e.g., the +z direction). For example, the fourth conductive layer 382 may include a conductive material (e.g., copper), but is not limited thereto. For example, the thickness of the fourth conductive layer 382 may be approximately 24 µm, but is not limited thereto. The fourth adhesive layer 383 may attach the fourth cover layer 384 on the fourth conductive layer 382. The fourth adhesive layer 383 may be disposed (or interposed) between the fourth conductive layer 382 and the fourth cover layer 384. For example, the thickness of the fourth adhesive layer 383 may be approximately 20 µm, but is not limited thereto. The fourth cover layer 384 may protect the layers 381, 382, and 383 within the fourth layer 380. The fourth cover layer 384 may be disposed on the fourth adhesive layer 383. The fourth cover layer 384 may be disposed above the fourth adhesive layer 383. For example, the fourth cover layer 384 may be in contact with one surface of the fourth adhesive layer 383 facing the fourth direction (e.g., the +z direction). For example, the fourth cover layer 384 may include polyimide (PI), but is not limited thereto. For example, the thickness of the fourth cover layer 384 may be approximately 12.5 µm, but is not limited thereto.

According to an embodiment, the at least one conductive via 310 may penetrate a portion of the fourth layer 380. The at least one conductive via 310 may penetrate the fourth conductive layer 382. The at least one conductive via 310 may penetrate the fourth base layer 381 and the fourth conductive layer 382. The at least one conductive via 310 may electrically connect the first conductive layer 322, the second conductive layer 332, the third conductive layer 372, and the fourth conductive layer 382 by penetrating the first layer 320, the second layer 330, the third layer 370, and a portion of the fourth layer 380.

According to an embodiment, the fifth layer 390 may be disposed (or extended) within the first support area 301 and the second support area 302. The fifth layer 390 may be disposed outside the flexible area 303. The fifth layer 390 may be spaced apart from the flexible area 303. For example, a portion of the fifth layer 390 may be disposed within the first support area 301. Another portion of the fifth layer 390 may be spaced apart (or disconnected) from the portion of the fifth layer 390 and disposed within the second support area 302. The fifth layer 390 may include a fifth base layer 391, a fifth conductive layer 392, a fifth adhesive layer 393, and/or a fifth cover layer 394. The fifth base layer 391 may be disposed under the first layer 320. For example, the fifth base layer 391 may be spaced apart from the first layer 320 along the third direction (e.g., the -z direction). The fifth base layer 391 may include polyimide (PI), but is not limited thereto. For example, the thickness of the fifth base layer 391 may be approximately 12 µm, but is not limited thereto. The fifth conductive layer 392 may include (or provide) a conductive pattern for transmission of a signal between the first printed circuit board 261 and the second printed circuit board 262. The fifth conductive layer 392 may be disposed on the fifth base layer 391. The fifth conductive layer 392 may be in contact with the fifth base layer 391. The fifth conductive layer 392 may be disposed under the fifth base layer 391. For example, the fifth conductive layer 392 may be in contact with a surface of the fifth base layer 391 facing the third direction (e.g., the -z direction). For example, the fifth conductive layer 392 may include a conductive material (e.g., copper), but is not limited thereto. For example, the thickness of the fifth conductive layer 392 may be approximately 12 µm, but is not limited thereto. The fifth adhesive layer 393 may attach the fifth cover layer 394 on the fifth conductive layer 392. The fifth adhesive layer 393 may be disposed (or interposed) between the fifth conductive layer 392 and the fifth cover layer 394. For example, the thickness of the fifth adhesive layer 393 may be approximately 20 µm, but is not limited thereto. The fifth cover layer 394 may protect the layers 391, 392, and 393 within the fifth layer 390. The fifth cover layer 394 may be disposed on the fifth adhesive layer 393. The fifth cover layer 394 may be disposed under the fifth adhesive layer 393. For example, the fifth cover layer 394 may be in contact with one surface of the fifth adhesive layer 393 facing the third direction (e.g., the -z direction). For example, the fifth cover layer 394 may include polyimide (PI), but is not limited thereto. For example, the thickness of the fifth cover layer 394 may be approximately 12.5 µm, but is not limited thereto.

According to an embodiment, the at least one conductive via 310 may penetrate a portion of the fifth layer 390. The at least one conductive via 310 may penetrate the fifth conductive layer 392. The at least one conductive via 310 may penetrate the fifth base layer 391 and the fifth conductive layer 392. The at least one conductive via 310 may electrically connect the first conductive layer 322, the second conductive layer 332, the third conductive layer 372, the fourth conductive layer 382, and the fifth conductive layer 392 by penetrating the first layer 320, the second layer 330, the third layer 370, a portion of the fourth layer 380, and a portion of the fifth layer 390. For example, each of the first conductive layer 322, the second conductive layer 332, the third conductive layer 372, the fourth conductive layer 382, and the fifth conductive layer 392 may be referred to as a signal pattern for transmission of a signal. For example, the first conductive layer 322 may be referred to as a first signal pattern, the second conductive layer 332 may be referred to as a second signal pattern, the third conductive layer 372 may be referred to as a third signal pattern, the fourth conductive layer 382 may be referred to as a fourth signal pattern, and the fifth conductive layer 392 may be referred to as a fifth signal pattern. The at least one conductive via 310 connecting the conductive layers 320, 330, 370, 380, and 390 may be referred to as a signal via.

According to an embodiment, the at least one attachment layer 400 may attach the layers 320, 330, 350, 370, 380 and 390 of the third printed circuit board 300. The at least one attachment layer 400 may be disposed (or extended) within the first support area 301 and the second support area 302. For example, the at least one attachment layer 400 may be disposed outside the flexible area 303. For example, the at least one attachment layer 400 may have relative rigidity. Since the at least one attachment layer 400 has relatively rigidity, each of the first support area 301 and the second support area 302 including the at least one attachment layer 400 may be referred to as a rigid area. For example, the at least one attachment layer 400 may be formed of a non-conductive material. For example, the at least one attachment layer 400 may be formed based on pre-impregnated materials (PREPREG, PPG). For example, the at least one attachment layer 400 may include an epoxy (FR-4, FR-5, G-2, G-11) material. However, it is not limited thereto. The at least one attachment layer 400 may be formed based on an adhesive material (e.g., pressure sensitive adhesive (PSA)). In case that the at least one attachment layer 400 does not have rigidity, the first support area 301 and the second support area 302 may have flexibility.

According to an embodiment, the at least one attachment layer 400 may include a first attachment layer 410, a second attachment layer 420, a third attachment layer 430, a fourth attachment layer 440, and/or a fifth attachment layer 450.

According to an embodiment, the first attachment layer 410 may be interposed between the radiating layer 340 and the first layer 320. The first attachment layer 410 may be interposed between the first protection layer 351 and the first base layer 321 of the first layer 320. The first attachment layer 410 may be in contact with the first protection layer 351 and the first base layer 321.

According to an embodiment, the second attachment layer 420 may be interposed between the radiating layer 340 and the second layer 330. The second attachment layer 420 may be interposed between the second protection layer 352 and the second base layer 331 of the second layer 340. The second attachment layer 420 may be in contact with the second protection layer 352 and the second base layer 331.

According to an embodiment, the third attachment layer 430 may be interposed between the second layer 330 and the third layer 370. The third attachment layer 430 may be interposed between the second cover layer 334 of the second layer 330 and the third base layer 371 of the third layer 370. The third attachment layer 430 may be in contact with the second cover layer 334 and the third base layer 371.

According to an embodiment, the fourth attachment layer 440 may be interposed between the third layer 370 and the fourth layer 380. The fourth attachment layer 440 may be interposed between the third cover layer 374 of the third layer 370 and the fourth base layer 381 of the fourth layer 380. The fourth attachment layer 440 may be in contact with the third cover layer 374 and the fourth base layer 381.

According to an embodiment, the fifth attachment layer 450 may be interposed between the first layer 320 and the fifth layer 390. The fifth attachment layer 450 may be interposed between the first cover layer 324 of the first layer 320 and the fifth base layer 391 of the fifth layer 390. The fifth attachment layer 450 may be in contact with the first cover layer 324 and the fifth base layer 391.

According to an embodiment, at least one air gap g1 may be located within the flexible area 303 of the third printed circuit board 300. The at least one air gap g1 may be formed as the at least one attachment layer 400 is disposed in the first support area 301 and the second support area 302, and the at least one attachment layer 400 is excluded from the flexible area 303. The at least one air gap g1 may be interposed between the radiating layer 340 and the first conductive layer 322. The at least one air gap g1 may be interposed between the radiating layer 340 and the second conductive layer 332. For example, the at least one air gap g1 may be located between the first layer 320 and the first protection layer 351. For example, the at least one air gap g1 may be located between the second layer 330 and the second protection layer 352. For example, the at least one air gap g1 may be located between the second layer 330 and the third layer 370.

As described above, the third printed circuit board 300 according to an embodiment may provide a structure capable of dispersing at least a portion of heat from the first housing 210 to the second housing 220 by the radiating layer 340 disposed within the first support area 301, the second support area 302, and the flexible area 303.

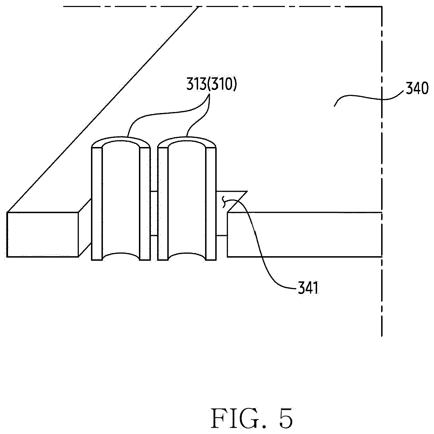

FIG. 5 is a partial cross-sectional view illustrating a relationship between an exemplary radiating layer and a conductive via according to an embodiment.

Referring to FIG. 5, according to an embodiment, at least one conductive via 310 may include a plurality of conductive vias 313 spaced apart from each other. The plurality of conductive vias 313 may be spaced apart from each other by a designated interval. According to an embodiment, at least one opening 341 (which may also be described as a window, hole, or aperture, in or through the radiating layer 340) may accommodate the plurality of conductive vias 313. The at least one opening 341 may cover (or surround) the plurality of conductive vias 313. For example, an area of the at least one opening 341 may be greater than the sum of areas of each of the plurality of conductive vias 313. Since the at least one opening 341 surrounds the plurality of conductive vias 313 from the outside, the plurality of conductive vias 313 and the radiating layer 340 may be electrically disconnected. In other words, the size and shape of the opening 341 may be arranged such that the conductive vias 313 may be accommodated within it, without the conductive vias 313 touching the radiating layer 340. There may be a gap (or gaps) between the edge (or edges) of the opening 341 and the sides of the conductive vias 313. The area of the opening 341 may be greater than the sum of the cross sectional areas of the conductive vias 313 passing through it. In the illustrated embodiment, the opening 341 accommodates the plurality of conductive vias 313.

As described above, a printed circuit board (e.g., the third printed circuit board 300 of FIG. 4) according to an embodiment may provide a structure in which the radiating layer 340 and the plurality of conductive vias 313 are spaced apart by the opening 341 accommodating the plurality of conductive vias 313.

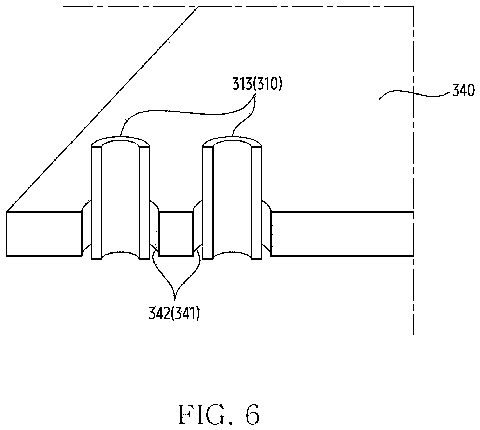

FIG. 6 is a partial cross-sectional view illustrating a relationship between an exemplary radiating layer and a conductive via according to an embodiment.

Referring to FIG. 6, according to an embodiment, at least one conductive via 310 may include a plurality of conductive vias 313 spaced apart from each other. The plurality of conductive vias 313 may be spaced apart from each other by a designated interval. According to an embodiment, at least one opening 341 may include a plurality of openings 342. Each of the plurality of openings 342 may correspond to a respective one of the plurality of conductive vias 313. Each of the plurality of openings 342 may accommodate a respective one of the plurality of conductive vias 313. Each of the plurality of openings 342 may cover (or surround) a respective one of the plurality of conductive vias 313. For example, one conductive via among the plurality of conductive vias 313 may be accommodated in one opening among the plurality of openings 342. For example, the number of the plurality of openings 342 may be substantially the same as the number of the plurality of conductive vias 313. Since each of the plurality of openings 342 surrounds each of the plurality of conductive vias 313 from the outside, the plurality of conductive vias 313 and the radiating layer 340 may be electrically disconnected.

As described above, a printed circuit board (e.g., the third printed circuit board 300 of FIG. 4) according to an embodiment may provide a structure in which the radiating layer 340 and the plurality of conductive vias 313 are spaced apart by the plurality of openings 342 accommodating each of the plurality of conductive vias 313.

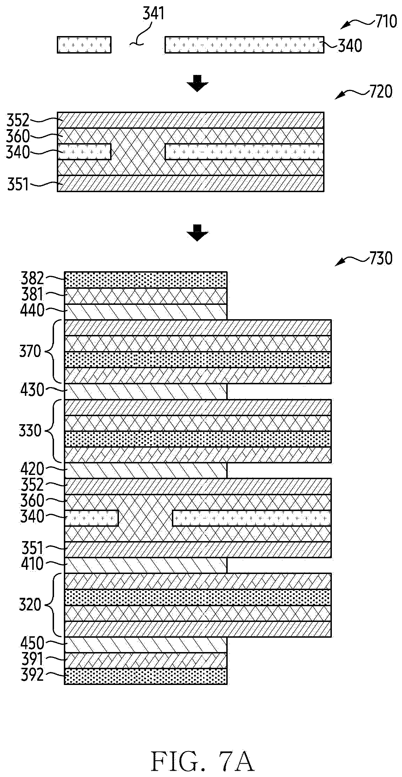

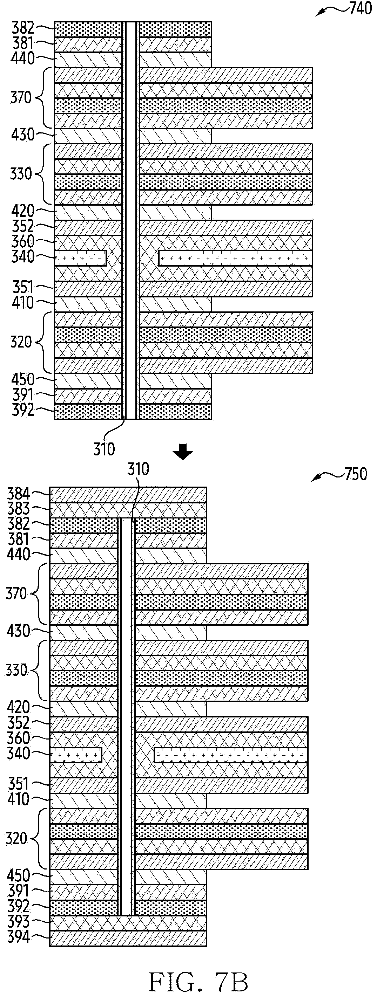

FIGS. 7A and 7B are drawings illustrating an example of manufacturing an exemplary third printed circuit board according to an embodiment.

Referring to FIGS. 7A and 7B, in a state 710, a radiating layer 340 may be prepared. For example, in the state 710, the radiating layer 340 including an opening 341 may be prepared. For example, the opening 341 may be formed by penetrating at least a portion of the radiating layer 340. For example, the opening 341 may be formed by omitting (or removing) at least a portion of the radiating layer 340.

In a state 720, the radiating layer 340, a first protection layer 351, a second protection layer 352, and a non-conductive layer 360 may be coupled. The radiating layer 340, the first protection layer 351, the second protection layer 352, and the non-conductive layer 360 may be coupled by being pressed by an external force. For example, pressure may be transferred to the first protection layer 351 and the second protection layer 352, after the first protection layer 351 and the second protection layer 352 are disposed on the radiating layer 340 on which the non-conductive layer 360 is applied. Since pressure is transferred to the first protection layer 351 and the second protection layer 352, a non-conductive material of the non-conductive layer 360 may flow into the opening 341.

In a state 730, a first attachment layer 410 and a first layer 320 may be stacked on the first protection layer 351. A fifth attachment layer 450, a fifth base layer 391, and a fifth conductive layer 392 may be stacked on the first layer 320. A second attachment layer 420 and a second layer 330 may be stacked on the second protection layer 352. A third attachment layer 430 and a third layer 370 may be stacked on the second layer 330. A fourth attachment layer 440, a fourth base layer 381, and a fourth conductive layer 382 may be stacked on the third layer 370.

In a state 740, at least one conductive via 310 may be formed. The at least one conductive via 310 may extend from the fourth conductive layer 382 to the fifth conductive layer 392. For example, the at least one conductive via 310 may penetrate the fourth conductive layer 382, the fourth base layer 381, the fourth attachment layer 440, the third layer 370, the third attachment layer 430, the second layer 330, the second attachment layer 420, the second protection layer 352, the non-conductive layer 360, the first protection layer 351, the first attachment layer 410, the first layer 320, the fifth attachment layer 450, the fifth base layer 391, and the fifth conductive layer 392. For example, the at least one conductive via 310 according to the state 740 may be referred to as a through hole via.

In a state 750, the fourth adhesive layer 383 and the fourth cover layer 384 may be stacked on the fourth conductive layer 382. A fifth adhesive layer 393 and a fifth cover layer 394 may be stacked on the fifth conductive layer 392. In the state 750, manufacturing of a third printed circuit board 300 may be completed.

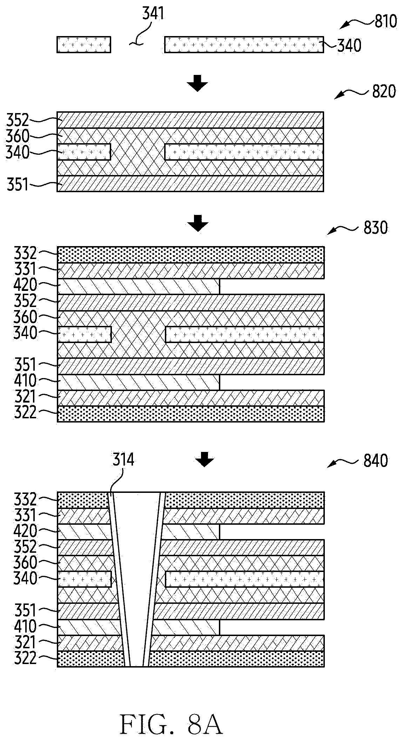

FIGS. 8A to 8D are drawings illustrating an example of manufacturing an exemplary third printed circuit board according to an embodiment.

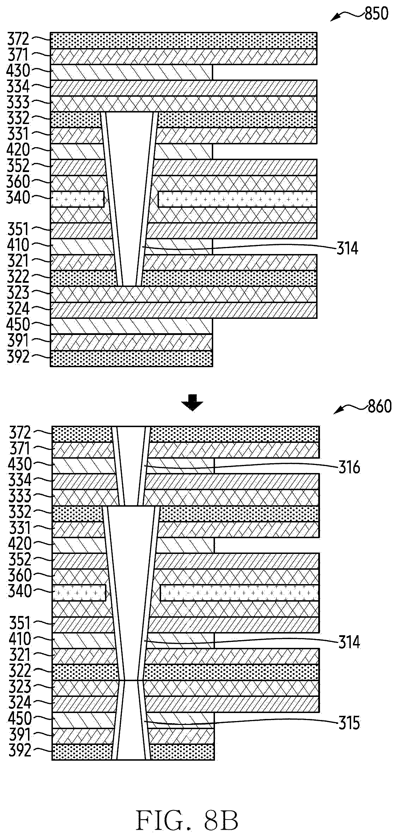

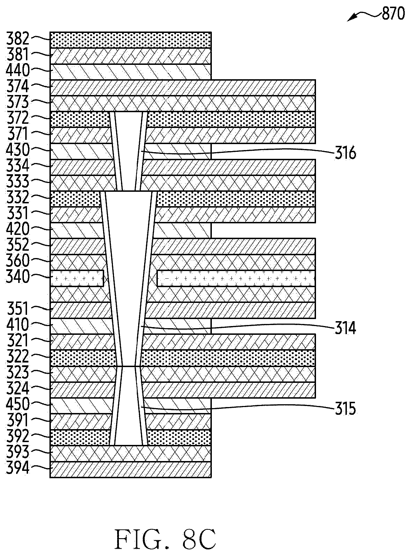

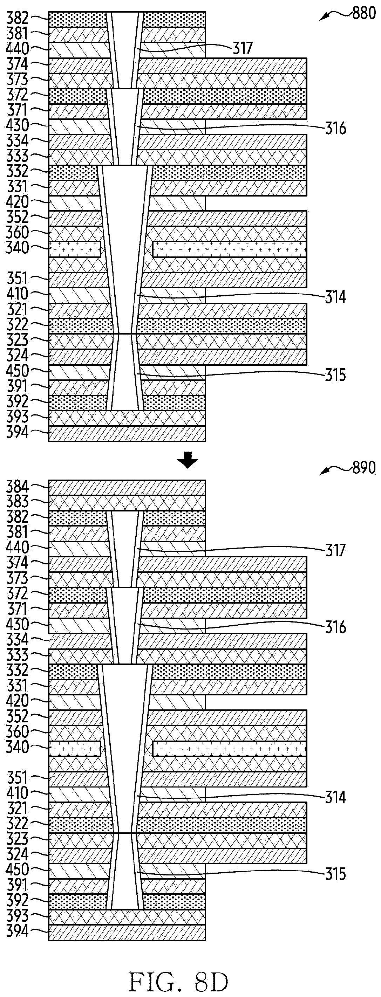

Referring to FIGS. 8A, 8B, 8C, and 8D, in a state 810, a radiating layer 340 may be prepared. For example, in the state 810, the radiating layer 340 including an opening 341 may be prepared. For example, the opening 341 may be formed by penetrating at least a portion of the radiating layer 340. For example, the opening 341 may be formed by omitting (or removing) at least a portion of the radiating layer 341.

In a state 820, the radiating layer 340, a first protection layer 351, a second protection layer 352, and a non-conductive layer 360 may be coupled. The radiating layer 340, the first protection layer 351, the second protection layer 352, and the non-conductive layer 360 may be coupled by being pressed by an external force. For example, pressure may be transferred to the first protection layer 351 and the second protection layer 352, after the first protection layer 351 and the second protection layer 352 are disposed on the radiating layer 340 on which the non-conductive layer 360 is applied. Since pressure is transferred to the first protection layer 351 and the second protection layer 352, a non-conductive material of the non-conductive layer 360 may flow into the opening 341.

In a state 830, a first attachment layer 410, a first base layer 321, and a first conductive layer 322 may be stacked on the first protection layer 351. A second attachment layer 420, a second base layer 331, and a second conductive layer 332 may be stacked on the second protection layer 352.

In a state 840, a first via member 314 for forming at least one conductive via 310 may be formed. The first via member 314 may extend from the second conductive layer 332 to the first conductive layer 322. For example, the first via member 314 may penetrate the second conductive layer 332, the second base layer 331, the second attachment layer 420, the second protection layer 352, the non-conductive layer 360, the first protection layer 351, the first attachment layer 410, the first base layer 321, and the first conductive layer 322. The first via member 314 may be spaced apart (or separated) from the radiating member 340.

In a state 850, a first adhesive layer 323, a first cover layer 324, a fifth attachment layer 450, a fifth base layer 391, and a fifth conductive layer 392 may be stacked on the first conductive layer 322. A second adhesive layer 333, a second cover layer 334, a third attachment layer 430, a third base layer 371, and a third conductive layer 372 may be stacked on the second conductive layer 332.

In a state 860, a second via member 315 and a third via member 316 for forming the at least one conductive via 310 may be connected to the first via member 314. The second via member 315 may extend from the first conductive layer 322 to the fifth conductive layer 392. For example, the second via member 315 may penetrate the first adhesive layer 323, the first cover layer 324, the fifth attachment layer 450, the fifth base layer 391, and the fifth conductive layer 392. The third via member 316 may extend from the second conductive layer 332 to the third conductive layer 372. For example, the third via member 316 may penetrate the second adhesive layer 333, the second cover layer 334, the third attachment layer 430, the third base layer 371, and the third conductive layer 372.

In a state 870, the fifth adhesive layer 393 and the fifth cover layer 394 may be stacked on the fifth conductive layer 392. A third adhesive layer 373, a third cover layer 374, a fourth attachment layer 440, a fourth base layer 381, and a fourth conductive layer 382 may be stacked on the third conductive layer 372.

In a state 880, a fourth via member 317 for forming the at least one conductive via 310 may be formed. The fourth via member 317 may extend from the third conductive layer 372 to the fourth conductive layer 382. The fourth via member 317 may penetrate the third adhesive layer 373, the third cover layer 374, the fourth attachment layer 440, the fourth base layer 381, and the fourth conductive layer 382. The fourth via member 317 may be connected to the third via member 316. Since the fourth via member 317 is connected to the third via member 316, and the second via member 315 and the third via member 316 are connected to the first via member 314, the at least one conductive via 310 may be formed. The at least one conductive via 310 may be referred to as a laser via.

In a state 890, a fourth adhesive layer 383 and a fourth cover layer 384 may be stacked on the fourth conductive layer 382. In the state 890, manufacturing of a third printed circuit board 300 may be completed.

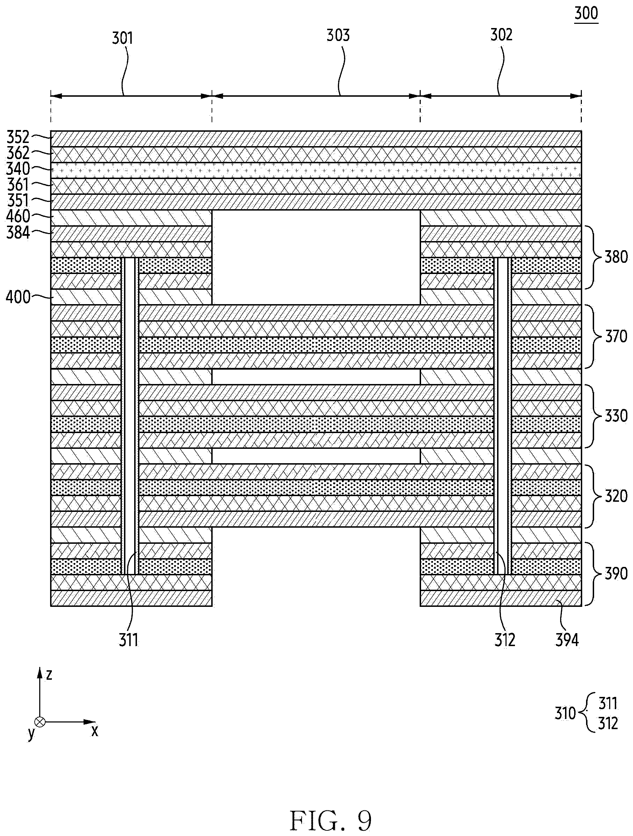

FIG. 9 is a cross-sectional view of an exemplary third printed circuit board according to an embodiment.

Since a third printed circuit board 300 of FIG. 9 may be a third printed circuit board 300 in which the location of a radiating layer 340 has been changed in the third printed circuit board 300 of FIG. 4, overlapping descriptions will be omitted.

Referring to FIG. 9, according to an embodiment, the radiating layer 340 may be disposed on a fourth layer 380. For example, the radiating layer 340 may be disposed on a fourth cover layer 384. For example, the radiating layer 340 may be disposed on the fourth cover layer 384 within a first support area 301, a second support area 302, and a flexible area 303. According to an embodiment, at least one attachment layer 400 may include a sixth attachment layer 460. The sixth attachment layer 460 may be disposed on the fourth cover layer 384. The sixth attachment layer 460 may be disposed within the first support area 301 and the second support area 302. For example, the sixth attachment layer 460 may not be disposed within the flexible area 303. A first protection layer 351 may be in contact with the sixth attachment layer 460.

However, it is not limited thereto. For example, the radiating layer 340 may be disposed on the fifth layer 390. For example, the radiating layer 340 may be disposed on the fifth cover layer 394. For example, the radiating layer 340 may be disposed on the fifth cover layer 394 within the first support area 301, the second support area 302, and the folding area 303.

According to an embodiment, at least one conductive via 310 may not penetrate the radiating layer 340. For example, the at least one conductive via 310 may not be inserted into the radiating layer 340. For example, one or more first conductive vias 311 and one or more second conductive vias 312 may not penetrate the radiating layer 340. Since the at least one conductive via 310 does not penetrate the radiating layer 340, the radiating layer 340 may not include at least one opening (e.g., the at least one opening 341 of FIG. 4).

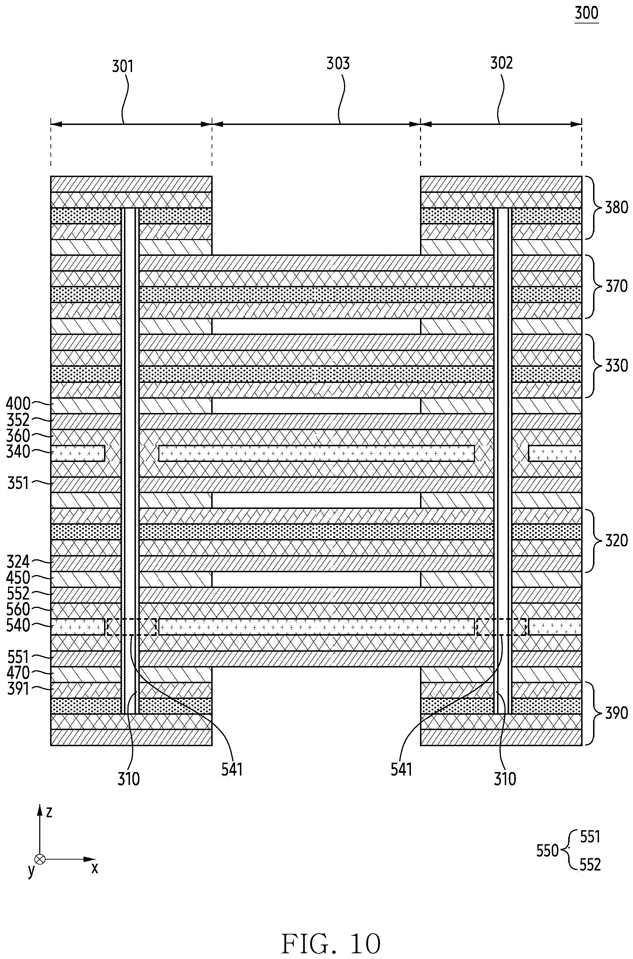

FIG. 10 is a cross-sectional view of an exemplary third printed circuit board according to an embodiment.

Since a third printed circuit board 300 of FIG. 10 may be a third printed circuit board 300 in which another (or second) radiating layer 540, at least one another protection layer 550 and/or another non-conductive layer 560 has been added to the third printed circuit board 300 of FIG. 4, overlapping descriptions will be omitted.

Referring to FIG. 10, according to an embodiment, the third printed circuit board 300 may include the another radiating layer 540, the at least one another protection layer 550, and/or the another non-conductive layer 560.

According to an embodiment, the another radiating layer 540 may be disposed within a first support area 301, a second support area 302, and a flexible area 303. The another radiating layer 540 may be formed of substantially the same material as a radiating layer 340. For example, the another radiating layers 540 may include a conductive material (e.g., graphite), but is not limited thereto. According to an embodiment, the another radiating layer 540 may be disposed (or interposed) between a first layer 320 and a fifth layer 390. For example, at least one attachment layer 400 may further include a seventh attachment layer 470. The seventh attachment layer 470 may be in contact with a fifth base layer 391. The another radiating layer 540 may be disposed between a fifth attachment layer 450 and the seventh attachment layer 470.

According to an embodiment, the at least one another protection layer 550 may protect the another radiating layer 540. The at least one another protection layer 550 may be disposed along the another radiating layer 540. The at least one another protection layer 550 may be disposed (or extended) within the first support area 301, the second support area 302, and the flexible area 303. The at least one another protection layer 550 may include a third protection layer 551 and a fourth protection layer 552. The third protection layer 551 may be disposed on the fifth base layer 391. For example, the third protection layer 551 may be in contact with the seventh attachment layer 470 on the fifth base layer 391. For example, the third protection layer 551 may be formed of substantially the same material as a first protection layer 351. The fourth protection layer 552 may be disposed on a first cover layer 324. For example, the fourth protection layer 552 may be in contact with the fifth attachment layer 450 under the first cover layer 324. For example, the fourth protection layer 552 may be formed of substantially the same material as a second protection layer 352.

According to an embodiment, the another non-conductive layer 560 may be disposed along the another radiating layer 540. The another non-conductive layer 560 may cover (or surround) the another radiating layer 540. The another non-conductive layer 560 may electrically disconnect the another radiating layer 540 and at least one conductive via 310. For example, at least a portion of the another non-conductive layer 560 may be disposed within at least one another opening 541 within the another radiating layer 540. For example, the at least a portion of the another non-conductive layer 560 may fill the at least one another opening 541 within the another radiating layer 540. For example, the another non-conductive layer 560 may include a non-conductive material.

However, it is not limited thereto, and the location of the another radiating layers 540, the at least one another protection layer 550, and the another non-conductive layer 560 may be changed according to embodiments. For example, the another radiating layer 540, the at least one another protection layer 550, and the another non-conductive layer 560 may be disposed between the radiating layer 340 and a second layer 330. For example, the another radiating layer 540, the at least one another protection layer 550, and the another non-conductive layer 560 may be disposed between the second layer 330 and a third layer 370. For example, the another radiating layer 540, the at least one another protection layer 550, and the another non-conductive layer 560 may be disposed between the third layer 370 and a fourth layer 380.

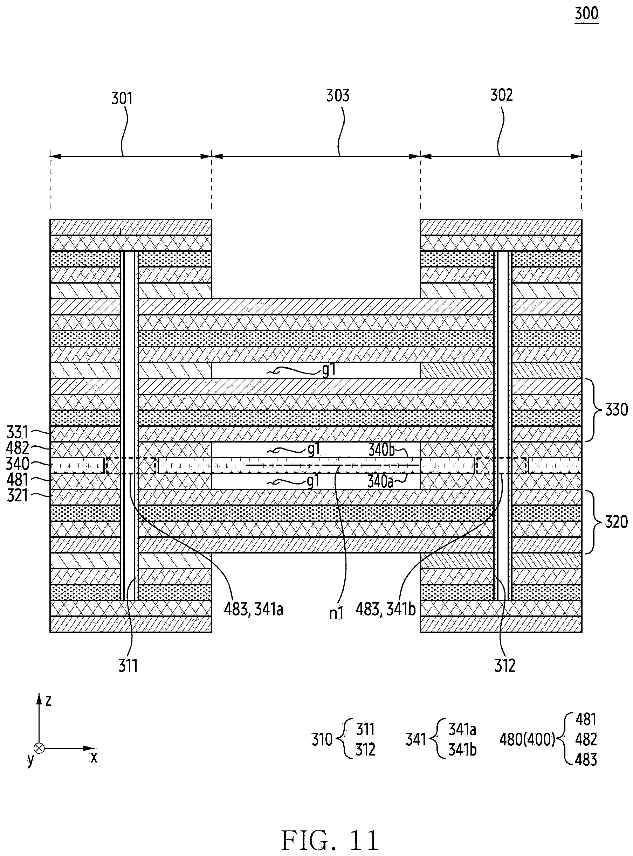

FIG. 11 is a cross-sectional view of an exemplary third printed circuit board according to an embodiment.

A third printed circuit board 300 of FIG. 11 may be a third printed circuit board 300 in which at least one protection layer 350, a non-conductive layer 360, a first attachment layer 410, and a second attachment layer 420 have been deleted from the third printed circuit board 300 of FIG. 4, overlapping descriptions will be omitted.

Referring to FIG. 11, according to an embodiment, at least one attachment layer 400 may include an eighth attachment layer 480. The eighth attachment layer 480 may be disposed within a first support area 301 and a second support area 302. The eighth attachment layer 480 may be disposed outside a flexible area 303. The eighth attachment layer 480 may electrically disconnect (or separate) a radiating layer 340 and at least one conductive via 310. For example, the eighth attachment layer 480 may include a non-conductive material (e.g., pre-impregnated materials (PREPREG, PPG)). According to an embodiment, the eighth attachment layer 480 may include a first portion 481, a second portion 482, and/or a third portion 483.

According to an embodiment, the first portion 481 may attach the radiating layer 340 on a first layer 320. The first portion 481 may be disposed (or interposed) between the radiating layer 340 and a first base layer 321 of the first layer 320. For example, the first portion 481 may be in contact with (or attached to) the first base layer 321 of the first layer 320 and one surface 340a of the radiating layer 340 within the first support area 301 and the second support area 302.

According to an embodiment, the second portion 482 may attach the radiating layer 340 to a second layer 330. The second portion 482 may be disposed (or interposed) between the radiating layer 340 and a second base layer 331 of the second layer 330. For example, the second portion 482 may be in contact with (or attached to) the second base layer 321 of the second layer 320 and another surface 340b of the radiating layer 340 within the first support area 301 and the second support area 302. According to an embodiment, the second portion 482 may be spaced apart (or disconnected) from the first portion 481. For example, the second portion 482 may be spaced apart from the first portion 481 along a direction in which the another surface 340b of the radiating layer 340 faces (e.g., the +z direction).

According to an embodiment, the third portion 483 may be disposed between the first portion 481 and the second portion 482. For example, the third portion 483 may connect the first portion 481 and the second portion 482. The third portion 483 may cover (or surround) the at least one conductive via 310. For example, the third portion 483 may be disposed along an outer surface of the at least one conductive via 310. The third portion 483 may be disposed within at least one opening 341. For example, the third portion 483 may fill the at least one opening 341. For example, the third portion 483 may cover (or surround) one or more first conductive vias 311 within a first opening 341a. For example, the third portion 483 may cover (or surround) one or more second conductive vias 312 within a second opening 341b. Since the third portion 483 including a non-conductive material fills the at least one opening 341, the at least one conductive via 310 and the radiating layer 340 may be electrically disconnected.

According to an embodiment, the radiating layer 340 may face a gap g1 within the flexible area 303. For example, the one surface 340a and the another surface 340b of the radiating layer 340 may face the gap g1 within the flexible area 303. For example, the radiating layer 340 may be exposed to the gap g1 within the flexible area 303.

As described above, the third printed circuit board 300 according to an embodiment may provide a structure capable of reducing a short circuit within the third printed circuit board 300 by the eighth attachment layer 480 that electrically disconnects the radiating layer 340 and the at least one conductive via 310.

Electronic components of an electronic device may be disposed in each of different housings. In case that heat generated as the electronic components operate is concentrated in one housing, the performance of the electronic components disposed in one housing may be reduced. The electronic device may need a structure capable of transferring at least a portion of heat generated in one housing to another housing.

Technical tasks to be achieved in the present disclosure are not limited to the technical tasks mentioned above, and other technical tasks not mentioned will be clearly understood by those having ordinary knowledge in the art to which the present disclosure belongs from the description below.

Effects obtainable in the present disclosure are not limited to the effects mentioned above, and other effects not mentioned will be clearly understood by those having ordinary knowledge in the art to which the present disclosure belongs from the description below.

An electronic device (e.g., the electronic device 200 of FIGS. 3A and 3B) is provided. According to an embodiment, the electronic device may comprise a first housing (e.g., the first housing 210 of FIGS. 3A and 3B). According to an embodiment, the electronic device may comprise a second housing (e.g., the second housing 220 of FIGS. 3A and 3B). According to an embodiment, the electronic device may comprise a hinge structure (e.g., the hinge structure 250 of FIGS. 3A and 3B) that couples (e.g. moveably couples) the first housing and the second housing. According to an embodiment, the electronic device may comprise a first printed circuit board (e.g., the third printed circuit board 300 of FIGS. 3A and 3B) extending from the first housing to the second housing (e.g. across the hinge structure to the second housing), and at least partially deformable by movement of the second housing relative to the first housing (e.g. by bending of the hinge structure). According to an embodiment, the first printed circuit board may comprise a first conductive layer (e.g., the first conductive layer 322 of FIG. 4). According to an embodiment, the first printed circuit board may comprise a second conductive layer (e.g., the second conductive layer 332 of FIG. 4) disposed on (or over, or above, or under) the first conductive layer. According to an embodiment, the first printed circuit board may comprise at least one conductive via (e.g., the at least one conductive via 310 of FIG. 4) extending from the first conductive layer to the second conductive layer. According to an embodiment, the first printed circuit board may comprise a radiating layer (e.g., the radiating layer 340 of FIG. 4) (which in certain embodiments may be described as a third conductive layer, a heat transferring layer, a heat dissipation layer, or a thermally conductive layer) interposed between the first conductive layer and the second conductive layer, and comprising an opening (e.g., the opening 341 of FIG. 4) surrounding the at least one conductive via. According to an embodiment, the first printed circuit board may comprise a non-conductive layer (e.g., the non-conductive layer 360 of FIG. 4), or some other body, member, or component comprising non-conductive material, at least partially disposed within the opening such that the radiating layer and the at least one conductive via are electrically disconnected (or, in other words, electrically insulated or isolated from one another by the electrically non-conductive material inside, or within, the opening). Thus, electrically non-conductive material may at least partly fill the volume inside the opening not occupied by the via, and so separate the via from the conductive material of the radiating layer. The non-conductive material may surround the portion of the via inside the opening, and so isolate it from the radiating layer.

According to an embodiment, the electronic device may provide a structure that may disperse at least a portion of heat of the first housing (e.g. heat generated inside the first housing) to the second housing by a radiating layer, for example disposed within a first support area, a second support area, and the flexible area. Thus, the electronic device may comprise a radiating layer, arranged to provide a thermally conductive path for transferring heat between the first and second housings.

According to an embodiment, the electronic device may comprise a second printed circuit board (e.g., the first printed circuit board 261 of FIGS. 3A and 3B) disposed in the first housing. According to an embodiment, the electronic device may comprise a third printed circuit board (e.g., the second printed circuit board 262 of FIGS. 3A and 3B) disposed in the second housing. According to an embodiment, the first printed circuit board may electrically connect the second printed circuit board and the third printed circuit board by extending from the second printed circuit board to the third printed circuit board, for example across the hinge structure.

The electronic device according to an embodiment may provide various functions to a user by the first printed circuit board connecting the second printed circuit board in the first housing and the third printed circuit board in the second housing.

According to an embodiment, the non-conductive layer may comprise a first area (or first portion) (e.g., the first area 361 of FIG. 4) disposed on one surface of the radiating layer facing the first conductive layer. According to an embodiment, the non-conductive layer may comprise a second area (or second portion) (e.g., the second area 362 of FIG. 4) facing the second conductive layer, and disposed on another surface of the radiating layer opposite to the one surface of the radiating layer. According to an embodiment, the non-conductive layer may comprise a third area (or third portion) (e.g., the third area 363 of FIG. 4) connecting the first area and the second area, and filling the opening (e.g. partially, or fully, but sufficiently to isolate the at least one conductive via from the radiating layer).

According to an embodiment, the electronic device may provide a structure in which the at least one conductive via and the radiating layer are electrically disconnected (or isolated or insulated from one another) by the non-conductive layer (or other non-conductive body or member) surrounding the radiating layer.

According to an embodiment, a thickness of the first area may be equal to a thickness of the second area.

According to an embodiment, the first printed circuit board may comprise a first protection layer (e.g., the first protection layer 351 of FIG. 4) interposed between the first area and the first conductive layer. According to an embodiment, the first printed circuit board may comprise a second protection layer (e.g., the second protection layer 352 of FIG. 4) interposed between the second area and the second conductive layer. According to an embodiment, a sum of a thickness of the first area and a thickness of the first protection layer may be equal to a sum of a thickness of the second area and a thickness of the second protection layer.

The electronic device according to an embodiment may provide a structure that may reduce a damage to the radiating layer by locating the radiating layer close to a neutral plane by symmetrically disposed layers based on the radiating layer.

According to an embodiment, the first printed circuit board may comprise a first support area (e.g., the first support area 301 of FIG. 4) disposed on the first housing. According to an embodiment, the first printed circuit board may comprise a second support area (e.g., the second support area 302 of FIG. 4) disposed on the second housing. According to an embodiment, the first printed circuit board may comprise a flexible area (e.g., the flexible area 331 of FIG. 4) disposed between the first support area and the second support area, connecting the first support area and the second support area, and having flexibility. According to an embodiment, the at least one conductive via may be disposed outside the flexible area.

The electronic device according to an embodiment may provide a structure that may reduce a damage to the at least one conductive via due to stress caused by deformation of the flexible area, since the at least one conductive via is disposed outside the flexible area.

According to an embodiment, the first support area and the second support area may have rigidity. In other words, the first support area and second support area may each have a rigidity greater than that of the flexible area.

The electronic device according to an embodiment may provide a structure that may reduce a damage to the first printed circuit board, since the first support area and the second support area have relatively rigidity (e.g. compared with the flexible area).

According to an embodiment, the at least one conductive via may comprise one or more first conductive vias (e.g., the one or more first conductive vias 311 of FIG. 4) disposed within the first support area. According to an embodiment, the at least one conductive via may comprise one or more second conductive vias (e.g., the one or more second conductive vias 312 of FIG. 4) disposed within the second support area. According to an embodiment, the opening may comprise a first opening (e.g., the first opening 341a of FIG. 4) surrounding the one or more first conductive vias. According to an embodiment, the opening may comprise a second opening (e.g., the second opening 341b of FIG. 4) surrounding the one or more second conductive vias.

The electronic device according to an embodiment may provide a structure in which the at least one conductive via and the radiating layer are electrically disconnected, since the radiating layer includes one or more openings corresponding to the at least one via.

According to an embodiment, the first printed circuit board may comprise an air gap (e.g., the air gap g1 of FIG. 4) located within the flexible area, and interposed between the first conductive layer and the radiating layer.

The electronic device according to an embodiment may provide a structure that may reduce a damage to the flexible area due to stress caused by deformation of the flexible area by at least one air gap that reduces stress within the flexible area.

According to an embodiment, the at least one conductive via may comprise a plurality of conductive vias (e.g., the plurality of conductive vias 313 of FIG. 5) spaced apart from each other. According to an embodiment, the opening may surround the plurality of conductive vias.

The electronic device according to an embodiment may provide a structure in which the at least one conductive via and the radiating layer are electrically disconnected, since the radiating layer includes the one or more openings that accommodate the plurality of vias.

According to an embodiment, the at least one conductive via may comprise a plurality of conductive vias (e.g., the plurality of conductive vias 313 of FIG. 6) spaced apart from each other. According to an embodiment, the opening may comprise a plurality of openings (e.g., the plurality of openings 342 of FIG. 6) each surrounding a respective one, or surrounding a respective group, of the plurality of conductive vias.

The electronic device according to an embodiment may provide a structure in which the at least one conductive via and the radiating layer are electrically disconnected, since the radiating layer includes the plurality of openings each corresponding to a respective one, or a respective group, of the plurality of vias.

According to an embodiment, the first printed circuit board may comprise an electronic component (e.g., the connectors 300a and 300b of FIGS. 3A and 3B) disposed on the first printed circuit board, and electrically connected to the first conductive layer and the second conductive layer, for example through solder.

According to an embodiment, the first printed circuit board may comprise a base layer (e.g., the first base layer 321 of FIG. 4) in contact with the first conductive layer between the radiating layer and the first conductive layer. According to an embodiment, the first printed circuit board may comprise an adhesive layer (e.g., the first adhesive layer 323 of FIG. 4) disposed on the first conductive layer. According to an embodiment, the first printed circuit board may comprise a cover layer (e.g., the first cover layer 324 of FIG. 4) disposed on the adhesive layer.

According to an embodiment, the radiating layer may comprise a conductive material.

The electronic device according to an embodiment may provide a structure that facilitates heat exchange between the first housing and the second housing, since the radiating layer includes the conductive material.

According to an embodiment, the electronic device may comprise a display (e.g., the display 230 of FIGS. 3A and 3B) disposed on the first housing and the second housing across the hinge structure. According to an embodiment, the first housing may comprise a first surface (e.g., the first surface 211 of FIGS. 2A and 2B) on which one area of the display is disposed, and a second surface (e.g., the second surface 212 of FIGS. 2A and 2B) opposite to the first surface. According to an embodiment, the second housing may comprise a third surface (e.g., the third surface 221 of FIGS. 2A and 2B) on which another area of the display is disposed, and a fourth surface (e.g., the fourth surface 222 of FIGS. 2A and 2B) opposite to the third surface. According to an embodiment, the hinge structure may be capable of changing into an unfolded state in which a direction in which the first surface faces is the same as a direction in which the third surface faces, and a folded state in which the direction in which the first surface faces is opposite to the direction in which the third surface faces. In other words, the hinge structure may be configured to permit transformation (or transition, or change of configuration or state) of the electronic device between its folded and unfolded states.

An electronic device (e.g., the electronic device 200 of FIGS. 3A and 3B) is provided. According to an embodiment, the electronic device may comprise a first housing (e.g., the first housing 210 of FIGS. 3A and 3B) comprising a first surface (e.g., the first surface 211 of FIGS. 2A and 2B) and a second surface (e.g., the second surface 212 of FIGS. 2A and 2B) opposite to the first surface. According to an embodiment, the electronic device may comprise a second housing (e.g., the second housing 220 of FIGS. 3A and 3B) comprising a third surface (e.g., the third surface 221 of FIGS. 2A and 2B) and a fourth surface (e.g., the fourth surface 222 of FIGS. 2A and 2B) opposite to the third surface. According to an embodiment, the electronic device may comprise a hinge structure (e.g., the hinge structure 250 of FIGS. 3A and 3B), moveably connecting the first housing and the second housing. The hinge structure may be arranged such that a state of the electronic device can be changed between an unfolded state, in which a direction in which the first surface faces is the same as a direction in which the third surface faces, and a folded state in which the direction in which the first surface faces is opposite to the direction in which the third surface faces. According to an embodiment, the electronic device may comprise a first printed circuit board (e.g., the third printed circuit board 300 of FIGS. 3A and 3B) extending from the first housing, for example across the hinge structure, to the second housing, and at least partially deformable by movement of the second housing relative to the first housing. According to an embodiment, the first printed circuit board may comprise a first conductive layer (e.g., the first conductive layer 322 of FIG. 4). According to an embodiment, the first printed circuit board may comprise a second conductive layer disposed over (or on, or above, or below) the first conductive layer. According to an embodiment, the first printed circuit board may comprise at least one conductive via (e.g., the at least one conductive via 310 of FIG. 4) penetrating the first conductive layer and the second conductive layer (e.g., the second conductive layer 332 of FIG. 4). According to an embodiment, the first printed circuit board may comprise a radiating layer (e.g., the radiating layer 340 of FIG. 4) disposed between the first conductive layer and the second conductive layer, and comprising an opening (e.g., the opening 341 of FIG. 4) penetrated by the at least one conductive via. According to an embodiment, the first printed circuit board may comprise a non-conductive layer (or non-conductive body or member) at least partially disposed within the opening such that the radiating layer and the at least one conductive via are electrically disconnected (e.g. isolated from one another). According to an embodiment, the radiating layer may be configured to transfer at least a portion of the heat in the first housing to the second housing.

According to an embodiment, the electronic device may provide a structure that may disperse at least a portion of the heat of the first housing to the second housing by the radiating layer disposed within the first support area, the second support area, and the flexible area.

According to an embodiment, the electronic device may comprise a second printed circuit board (e.g., the first printed circuit board 261 of FIGS. 3A and 3B) disposed in the first housing. According to an embodiment, the electronic device may comprise a third printed circuit board (e.g., the second printed circuit board 262 of FIGS. 3A and 3B) disposed in the second housing. According to an embodiment, the first printed circuit board may electrically connect the second printed circuit board and the third printed circuit board by extending from the second printed circuit board, e.g. across the hinge structure, to the third printed circuit board.

The electronic device according to an embodiment may provide various functions to a user by the first printed circuit board connecting the second printed circuit board in the first housing and the third printed circuit board in the second housing.

According to an embodiment, the non-conductive layer may comprise a first area (e.g., the first area 361 of FIG. 4) disposed on one surface of the radiating layer facing the first conductive layer. According to an embodiment, the non-conductive layer may comprise a second area (e.g., the second area 362 of FIG. 4) facing the second conductive layer, and disposed on another surface of the radiating layer opposite to the one surface of the radiating layer. According to an embodiment, the non-conductive layer may comprise a third area (e.g., the third area 363 of FIG. 4) connecting the first area and the second area and filling the opening.

According to an embodiment, the electronic device may provide a structure in which the at least one conductive via and the radiating layer are electrically disconnected by the non-conductive layer surrounding the radiating layer.

According to an embodiment, the first printed circuit board may comprise a first support area (e.g., the first support area 301 of FIG. 4) disposed on the first housing. According to an embodiment, the first printed circuit board may comprise a second support area (e.g., the second support area 302 of FIG. 4) disposed on the second housing. According to an embodiment, the first printed circuit board may comprise a flexible area (e.g., the flexible area 331 of FIG. 4) disposed between the first support area and the second support area, connecting the first support area and the second support area, and having flexibility. According to an embodiment, the at least one conductive via may be disposed outside the flexible area.

The electronic device according to an embodiment may provide a structure that may reduce a damage to the at least one conductive via due to stress caused by deformation of the flexible area, since the at least one conductive via is disposed outside the flexible area.

According to an embodiment, the radiating layer may comprise a conductive material.

The electronic device according to an embodiment may provide a structure that facilitates heat exchange between the first housing and the second housing, since the radiating layer includes the conductive material.

It should be understood that when an element is referred to as being "on" another element, it may be directly on the another element or there may be intervening elements therebetween. In contrast, when an element is referred to as being "directly on" another element, no intervening elements exist.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to, " "connected with, " or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200) comprising:
a first housing (210);
a second housing (220);
a hinge structure (250) that moveably couples the first housing (210) and the second housing (220); and
a first printed circuit board (300) extending from the first housing (210) across the hinge structure (250) to the second housing (220), and at least partially deformable by movement of the second housing (220) relative to the first housing (210), and
wherein the first printed circuit board (300) comprises:
a first conductive layer (322);
a second conductive layer (332) disposed on the first conductive layer (322);
at least one conductive via (310) connecting the first conductive layer (322) and the second conductive layer (332);
a heat dissipation layer (340) interposed between the first conductive layer (322) and the second conductive layer (332), and comprising an opening (341) surrounding the at least one conductive via (310); and
a non-conductive layer (360) at least partially disposed within the opening (341) such that the heat dissipation layer (340) and the at least one conductive via (310) are electrically disconnected.

2. The electronic device (101; 200) of claim 1, further comprising:
a second printed circuit board (261) disposed in the first housing (210); and
a third printed circuit board (262) disposed in the second housing (220), and
wherein the first printed circuit board (300) electrically connects the second printed circuit board (261) and the third printed circuit board (262) by extending from the second printed circuit board 261 to the third printed circuit board (262) across the hinge structure (250).

3. The electronic device (101; 200) of any one of claims 1 and 2,
wherein the non-conductive layer (360) comprises:
a first area (361) disposed on one surface (340a) of the heat dissipation layer (340) facing the first conductive layer (322);
a second area (362) facing the second conductive layer (332), and disposed on another surface (340b) of the heat dissipation layer (340) opposite to the one surface (340a) of the heat dissipation layer (340); and
a third area (363) connecting the first area (361) and the second area (362), and filling the opening (341).

4. The electronic device (101; 200) of claim 3,
wherein a thickness of the first area (361) is equal to a thickness of the second area (362).

5. The electronic device (101; 200) of claim 3,
wherein the first printed circuit board (300) comprising:
a first protection layer (351) interposed between the first area (361) and the first conductive layer (322); and
a second protection layer (352) interposed between the second area (362) and the second conductive layer (332), and
wherein a sum of a thickness of the first area (361) and a thickness of the first protection layer (351) is equal to a sum of a thickness of the second area (362) and a thickness of the second protection layer (352).

6. The electronic device (101; 200) of any one of claims 1 to 5,
wherein the first printed circuit board (300) further comprises:
a first support area (301) disposed on the first housing (210);
a second support area (302) disposed on the second housing (220); and
a flexible area (303) disposed between the first support area (301) and the second support area (302), connecting the first support area (301) and the second support area (302), and having flexibility, and
wherein the at least one conductive via (310) is disposed outside the flexible area (303).

7. The electronic device (101; 200) of claim 6,
wherein the first support area (301) and the second support area (302) have rigidity.

8. The electronic device (101; 200) of claim 6,
wherein the at least one conductive via (310) comprises:
one or more first conductive vias (311) disposed within the first support area (301); and
one or more second conductive vias (312) disposed within the second support area (302), and
wherein the opening (341) comprises:
a first opening surrounding the one or more first conductive vias (311); and
a second opening surrounding the one or more second conductive vias (312).

9. The electronic device (101; 200) of claim 6,
wherein the first printed circuit board (300) comprises an air gap (g1) located within the flexible area (303), and interposed between the first conductive layer (322) and the heat dissipation layer (340).

10. The electronic device (101; 200) of any one of claims 1 to 9,
wherein the at least one conductive via (310) comprises a plurality of conductive vias (313) spaced apart from each other, and
wherein the opening (341) surrounds the plurality of conductive vias (313).

11. The electronic device (101; 200) of any one of claims 1 to 10,
wherein the at least one conductive via (310) comprises a plurality of conductive vias (313) spaced apart from each other, and
wherein the opening (341) comprises a plurality of openings (342) surrounding each of the plurality of the conductive vias (313).

12. The electronic device (101; 200) of any one of claims 1 to 10,
further comprising an electronic component (300a) disposed on the first printed circuit board (300), and electrically connected to the first conductive layer (322) and the second conductive layer (332) through solder.

13. The electronic device (101; 200) of any one of claims 1 to 12,
wherein the first printed circuit board (300) further comprises:
a base layer (321) in contact with the first conductive layer (322) between the heat dissipation layer (340) and the first conductive layer (322);
an adhesive layer (323) disposed on the first conductive layer (322); and
a cover layer (324) disposed on the adhesive layer (323).

14. The electronic device (101; 200) of any one of claims 1 to 13,
wherein the heat dissipation layer (340) comprises a conductive material.

15. The electronic device (101; 200) of any one of claims 1 to 14, further comprising a display (230) disposed on the first housing (210) and the second housing (220) across the hinge structure (250), and wherein:
the first housing (210) comprises a first surface (211) on which one area of the display (230) is disposed, and a second surface (212) opposite to the first surface (211); and
wherein the second housing (220) comprises a third surface (221) on which another area of the display (230) is disposed, and a fourth surface (222) opposite to the third surface (221); and
wherein the hinge structure (250) is capable of changing into an unfolded state in which a direction in which the first surface (211) faces is the same as a direction in which the third surface (221) faces, and a folded state in which the direction in which the first surface (211) faces is opposite to the direction in which the third surface (221) faces.

## Patentansprüche

1. Elektronische Vorrichtung (101; 200), umfassend:
ein erstes Gehäuse (210);
ein zweites Gehäuse (220);
eine Scharnierstruktur (250), die das erste Gehäuse (210) und das zweite Gehäuse (220) bewegbar koppelt; und
eine erste Leiterplatte (300), die sich von dem ersten Gehäuse (210) über die Scharnierstruktur (250) zu dem zweiten Gehäuse (220) erstreckt und durch eine Bewegung des zweiten Gehäuses (220) relativ zu dem ersten Gehäuse (210) mindestens teilweise verformbar ist, und
wobei die erste Leiterplatte (300) Folgendes umfasst:
eine erste leitende Schicht (322);
eine zweite leitende Schicht (332), die auf der ersten leitenden Schicht (322) angeordnet ist;
mindestens eine leitende Durchkontaktierung (310), die die erste leitende Schicht (322) und die zweite leitende Schicht (332) verbindet;
eine Wärmeableitungsschicht (340), die zwischen der ersten leitenden Schicht (322) und der zweiten leitenden Schicht (332) eingefügt ist und eine Öffnung (341) umfasst, die die mindestens eine leitende Durchkontaktierung (310) umgibt; und
eine nicht leitende Schicht (360), die mindestens teilweise innerhalb der Öffnung (341) angeordnet ist, sodass die Wärmeableitungsschicht (340) und die mindestens eine leitende Durchkontaktierung (310) elektrisch getrennt sind.

2. Elektronische Vorrichtung (101; 200) nach Anspruch 1, ferner umfassend:
eine zweite Leiterplatte (261), die in dem ersten Gehäuse (210) angeordnet ist; und
eine dritte Leiterplatte (262), die in dem zweiten Gehäuse (220) angeordnet ist, und
wobei die erste Leiterplatte (300) die zweite Leiterplatte (261) und die dritte Leiterplatte (262) elektrisch verbindet, indem sie sich von der zweiten Leiterplatte 261 zu der dritten Leiterplatte (262) über die Scharnierstruktur (250) erstreckt.

3. Elektronische Vorrichtung (101; 200) nach einem der Ansprüche 1 und 2,
wobei die nicht leitende Schicht (360) Folgendes umfasst:
einen ersten Bereich (361), der auf einer Oberfläche (340a) der Wärmeableitungsschicht (340) angeordnet ist, die der ersten leitenden Schicht (322) zugewandt ist;
einen zweiten Bereich (362), der der zweiten leitenden Schicht (332) zugewandt ist und auf einer anderen Oberfläche (340b) der Wärmeableitungsschicht (340), die der einen Oberfläche (340a) der Wärmeableitungsschicht (340) gegenüberliegt, angeordnet ist; und
einen dritten Bereich (363), der den ersten Bereich (361) und den zweiten Bereich (362) verbindet und die Öffnung (341) füllt.

4. Elektronische Vorrichtung (101; 200) nach Anspruch 3,
wobei eine Dicke des ersten Bereichs (361) gleich einer Dicke des zweiten Bereichs (362) ist.

5. Elektronische Vorrichtung (101; 200) nach Anspruch 3,
wobei die erste Leiterplatte (300) Folgendes umfassend:
eine erste Schutzschicht (351), die zwischen dem ersten Bereich (361) und der ersten leitenden Schicht (322) eingefügt ist; und
eine zweite Schutzschicht (352), die zwischen dem zweiten Bereich (362) und der zweiten leitenden Schicht (332) eingefügt ist, und
wobei eine Summe einer Dicke des ersten Bereichs (361) und einer Dicke der ersten Schutzschicht (351) gleich einer Summe einer Dicke des zweiten Bereichs (362) und einer Dicke der zweiten Schutzschicht (352) ist.

6. Elektronische Vorrichtung (101; 200) nach einem der Ansprüche 1 bis 5,
wobei die erste Leiterplatte (300) ferner Folgendes umfasst:
einen ersten Stützbereich (301), der an dem ersten Gehäuse (210) angeordnet ist;
einen zweiten Stützbereich (302), der an dem zweiten Gehäuse (220) angeordnet ist; und
einen flexiblen Bereich (303), der zwischen dem ersten Stützbereich (301) und dem zweiten Stützbereich (302) angeordnet ist, den ersten Stützbereich (301) und den zweiten Stützbereich (302) verbindet und Flexibilität aufweist, und
wobei die mindestens eine leitende Durchkontaktierung (310) außerhalb des flexiblen Bereichs (303) angeordnet ist.

7. Elektronische Vorrichtung (101; 200) nach Anspruch 6,
wobei der erste Stützbereich (301) und der zweite Stützbereich (302) Steifigkeit aufweisen.

8. Elektronische Vorrichtung (101; 200) nach Anspruch 6,
wobei die mindestens eine leitende Durchkontaktierung (310) Folgendes umfasst:
eine oder mehrere erste leitende Durchkontaktierungen (311), die innerhalb des ersten Stützbereichs (301) angeordnet sind; und
eine oder mehrere zweite leitende Durchkontaktierungen (312), die innerhalb des zweiten Stützbereichs (302) angeordnet sind, und
wobei die Öffnung (341) Folgendes umfasst:
eine erste Öffnung, die die eine oder mehreren ersten leitenden Durchkontaktierungen (311) umgibt; und
eine zweite Öffnung, die die eine oder die mehreren zweiten leitenden Durchkontaktierungen (312) umgibt.

9. Elektronische Vorrichtung (101; 200) nach Anspruch 6,
wobei die erste Leiterplatte (300) einen Luftspalt (g1) umfasst, der sich innerhalb des flexiblen Bereichs (303) befindet und zwischen der ersten leitenden Schicht (322) und der Wärmeableitungsschicht (340) eingefügt ist.

10. Elektronische Vorrichtung (101; 200) nach einem der Ansprüche 1 bis 9,
wobei die mindestens eine leitende Durchkontaktierung (310) eine Vielzahl von leitenden Durchkontaktierungen (313) umfasst, die voneinander beabstandet sind, und
wobei die Öffnung (341) die Vielzahl von leitenden Durchkontaktierungen (313) umgibt.

11. Elektronische Vorrichtung (101; 200) nach einem der Ansprüche 1 bis 10,
wobei die mindestens eine leitende Durchkontaktierung (310) eine Vielzahl von leitenden Durchkontaktierungen (313) umfasst, die voneinander beabstandet sind, und
wobei die Öffnung (341) eine Vielzahl von Öffnungen (342) umfasst, die jede aus der Vielzahl von leitenden Durchkontaktierungen (313) umgeben.

12. Elektronische Vorrichtung (101; 200) nach einem der Ansprüche 1 bis 10,
ferner umfassend eine elektronische Komponente (300a), die auf der ersten Leiterplatte (300) angeordnet ist und durch Lötmetall elektrisch mit der ersten leitenden Schicht (322) und der zweiten leitenden Schicht (332) verbunden ist.

13. Elektronische Vorrichtung (101; 200) nach einem der Ansprüche 1 bis 12,
wobei die erste Leiterplatte (300) ferner Folgendes umfasst:
eine Basisschicht (321) in Kontakt mit der ersten leitenden Schicht (322) zwischen der Wärmeableitungsschicht (340) und der ersten leitenden Schicht (322);
eine Haftschicht (323), die auf der ersten leitenden Schicht (322) angeordnet ist; und
eine Deckschicht (324), die auf der Haftschicht (323) angeordnet ist.

14. Elektronische Vorrichtung (101; 200) nach einem der Ansprüche 1 bis 13,
wobei die Wärmeableitungsschicht (340) ein leitendes Material umfasst.

15. Elektronische Vorrichtung (101; 200) nach einem der Ansprüche 1 bis 14, ferner umfassend eine Anzeige (230), die an dem ersten Gehäuse (210) und dem zweiten Gehäuse (220) über die Scharnierstruktur (250) hinweg angeordnet ist, und wobei:
das erste Gehäuse (210) eine erste Oberfläche (211), auf der ein Bereich der Anzeige (230) angeordnet ist, und eine zweite Oberfläche (212) gegenüber der ersten Oberfläche (211) umfasst; und
wobei das zweite Gehäuse (220) eine dritte Oberfläche (221), auf der ein anderer Bereich der Anzeige (230) angeordnet ist, und eine vierte Oberfläche (222) gegenüber der dritten Oberfläche (221) umfasst; und
wobei die Scharnierstruktur (250) in der Lage ist, in einen aufgeklappten Zustand, in dem eine Richtung, der die erste Oberfläche (211) zugewandt ist, die gleiche ist wie eine Richtung, der die dritte Oberfläche (221) zugewandt ist, und in einen zusammengeklappten Zustand zu wechseln, in dem die Richtung, der die erste Oberfläche (211) zugewandt ist, der Richtung gegenüberliegt, der die dritte Oberfläche (221) zugewandt ist.

## Revendications

1. Dispositif électronique (101 ; 200) comprenant :
un premier boîtier (210) ;
un second boîtier (220) ;
une structure de charnière (250) qui couple de manière mobile le premier boîtier (210) et le second boîtier (220) ; et
une première carte de circuit imprimé (300) s'étendant à partir du premier boîtier (210) à travers la structure de charnière (250) jusqu'au second boîtier (220), et au moins partiellement déformable par un mouvement du second boîtier (220) par rapport au premier boîtier (210), et
dans lequel la première carte de circuit imprimé (300) comprend :
une première couche conductrice (322) ;
une seconde couche conductrice (332) disposée sur la première couche conductrice (322) ;
au moins un trou d'interconnexion conducteur (310) connectant la première couche conductrice (322) et la seconde couche conductrice (332) ;
une couche de dissipation de chaleur (340) interposée entre la première couche conductrice (322) et la seconde couche conductrice (332), et comprenant une ouverture (341) entourant l'au moins un trou d'interconnexion conducteur (310) ; et
une couche non conductrice (360) disposée au moins partiellement à l'intérieur de l'ouverture (341) de sorte que la couche de dissipation de chaleur (340) et l'au moins un trou d'interconnexion conducteur (310) soient électriquement déconnectés.

2. Dispositif électronique (101 ; 200) de la revendication 1, comprenant en outre :
une deuxième carte de circuit imprimé (261) disposée dans le premier boîtier (210) ; et
une troisième carte de circuit imprimé (262) disposée dans le second boîtier (220), et
dans lequel la première carte de circuit imprimé (300) connecte électriquement la deuxième carte de circuit imprimé (261) et la troisième carte de circuit imprimé (262) en s'étendant à partir de la deuxième carte de circuit imprimé 261 jusqu'à la troisième carte de circuit imprimé (262) à travers la structure de charnière (250).

3. Dispositif électronique (101 ; 200) de l'une quelconque des revendications 1 et 2,
dans lequel la couche non conductrice (360) comprend :
une première zone (361) disposée sur une surface (340a) de la couche de dissipation de chaleur (340) faisant face à la première couche conductrice (322) ;
une deuxième zone (362) faisant face à la seconde couche conductrice (332), et disposée sur une autre surface (340b) de la couche de dissipation de chaleur (340) opposée à la première surface (340a) de la couche de dissipation de chaleur (340) ; et
une troisième zone (363) connectant la première zone (361) et la deuxième zone (362), et remplissant l'ouverture (341).

4. Dispositif électronique (101 ; 200) de la revendication 3,
dans lequel une épaisseur de la première zone (361) est égale à une épaisseur de la deuxième zone (362).

5. Dispositif électronique (101 ; 200) de la revendication 3,
dans lequel la première carte de circuit imprimé (300) comprenant :
une première couche de protection (351) interposée entre la première zone (361) et la première couche conductrice (322) ; et
une seconde couche de protection (352) interposée entre la deuxième zone (362) et la seconde couche conductrice (332), et
dans lequel une somme d'une épaisseur de la première zone (361) et d'une épaisseur de la première couche de protection (351) est égale à une somme d'une épaisseur de la deuxième zone (362) et d'une épaisseur de la seconde couche de protection (352).

6. Dispositif électronique (101 ; 200) de l'une quelconque des revendications 1 à 5,
dans lequel la première carte de circuit imprimé (300) comprend en outre :
une première zone de support (301) disposée sur le premier boîtier (210) ;
une seconde zone de support (302) disposée sur le second boîtier (220) ; et
une zone souple (303) disposée entre la première zone de support (301) et la seconde zone de support (302), connectant la première zone de support (301) et la seconde zone de support (302), et comportant de la souplesse, et
dans lequel l'au moins un trou d'interconnexion conducteur (310) est disposé à l'extérieur de la zone souple (303).

7. Dispositif électronique (101 ; 200) de la revendication 6,
dans lequel la première zone de support (301) et la seconde zone de support (302) comportent une rigidité.

8. Dispositif électronique (101 ; 200) de la revendication 6,
dans lequel l'au moins un trou d'interconnexion conducteur (310) comprend :
un ou plusieurs premiers trous d'interconnexion conducteurs (311) disposés à l'intérieur de la première zone de support (301) ; et
un ou plusieurs seconds trous d'interconnexion conducteurs (312) disposés à l'intérieur de la seconde zone de support (302), et
dans lequel l'ouverture (341) comprend :
une première ouverture entourant les un ou plusieurs premiers trous d'interconnexion conducteurs (311) ; et
une seconde ouverture entourant les un ou plusieurs seconds trous d'interconnexion conducteurs (312).

9. Dispositif électronique (101 ; 200) de la revendication 6,
dans lequel la première carte de circuit imprimé (300) comprend un entrefer (g1) situé à l'intérieur de la zone souple (303), et interposé entre la première couche conductrice (322) et la couche de dissipation de chaleur (340).

10. Dispositif électronique (101 ; 200) de l'une quelconque des revendications 1 à 9,
dans lequel l'au moins un trou d'interconnexion conducteur (310) comprend une pluralité de trous d'interconnexion conducteurs (313) espacés les uns des autres, et
dans lequel l'ouverture (341) entoure la pluralité de trous d'interconnexion conducteurs (313).

11. Dispositif électronique (101 ; 200) de l'une quelconque des revendications 1 à 10,
dans lequel l'au moins un trou d'interconnexion conducteur (310) comprend une pluralité de trous d'interconnexion conducteurs (313) espacés les uns des autres, et
dans lequel l'ouverture (341) comprend une pluralité d'ouvertures (342) entourant chacun de la pluralité de trous d'interconnexion conducteurs (313).

12. Dispositif électronique (101 ; 200) de l'une quelconque des revendications 1 à 10,
comprenant en outre un composant électronique (300a) disposé sur la première carte de circuit imprimé (300), et connecté électriquement à la première couche conductrice (322) et à la seconde couche conductrice (332) par soudure.

13. Dispositif électronique (101 ; 200) de l'une quelconque des revendications 1 à 12,
dans lequel la première carte de circuit imprimé (300) comprend en outre :
une couche de base (321) en contact avec la première couche conductrice (322) entre la couche de dissipation de chaleur (340) et la première couche conductrice (322) ;
une couche adhésive (323) disposée sur la première couche conductrice (322) ; et
une couche de couverture (324) disposée sur la couche adhésive (323).

14. Dispositif électronique (101 ; 200) de l'une quelconque des revendications 1 à 13,
dans lequel la couche de dissipation de chaleur (340) comprend un matériau conducteur.

15. Dispositif électronique (101 ; 200) de l'une quelconque des revendications 1 à 14, comprenant en outre un affichage (230) disposé sur le premier boîtier (210) et le second boîtier (220) à travers la structure de charnière (250), et dans lequel :
le premier boîtier (210) comprend une première surface (211) sur laquelle une zone de l'affichage (230) est disposée, et une deuxième surface (212) opposée à la première surface (211) ; et
dans lequel le second boîtier (220) comprend une troisième surface (221) sur laquelle une autre zone de l'affichage (230) est disposée, et une quatrième surface (222) opposée à la troisième surface (221) ; et
dans lequel la structure de charnière (250) est capable de passer dans un état déplié où une direction dans laquelle la première surface (211) est orientée est la même qu'une direction dans laquelle la troisième surface (221) est orientée, et un état plié où la direction dans laquelle la première surface (211) est orientée est opposée à la direction dans laquelle la troisième surface (221) est orientée.
